(19) Europäisches Patentamt European Patent Office Office européen des brevets

(11) **EP 4 554 081 B1**

(12) **EUROPEAN PATENT SPECIFICATION**

(45) Date of publication and mention of the grant of the patent:
**29.07.2026 Bulletin 2026/31**

(21) Application number: **24182977.9**

(22) Date of filing: **19.06.2024**

(51) International Patent Classification (IPC):
*H02P 21/18* *(2016.01)*

(52) Cooperative Patent Classification (CPC):
**H02P 21/18;** H02P 2207/05

(54) **POWER CONVERSION DEVICE**

LEISTUNGSWANDLER

DISPOSITIF DE CONVERSION DE PUISSANCE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **08.11.2023 JP 2023190952**

(43) Date of publication of application:
**14.05.2025 Bulletin 2025/20**

(73) Proprietor: **Hitachi Industrial Equipment Systems Co., Ltd.**
**Tokyo 101-0021 (JP)**

(72) Inventors:
• **TOBARI, Kazuaki**
**Tokyo 100-8280 (JP)**
• **TAGUCHI, Yoshiyuki**
**Tokyo 101-0021 (JP)**
• **IWASE, Yuta**
**Tokyo 101-0021 (JP)**

(74) Representative: **MERH-IP Matias Erny Reichl Hoffmann**
**Patentanwälte PartG mbB**
**Paul-Heyse-Straße 29**
**80336 München (DE)**

(56) References cited:
| EP-A2- 1 681 762 | CN-A- 116 830 450 |
| US-A1- 2007 126 391 | US-A1- 2021 328 537 |
| US-A1- 2024 097 589 | |

EP 4 554 081 B1

**Description**

BACKGROUND OF THE INVENTION

1. Field of the Invention

The present invention relates to a power conversion device.

2. Description of the Related Art

As a stable and highly-accurate control method in the low speed range of position sensorless control, as described in Patent No. 4402600, there is a description of a technique for computing a reactive power and estimating the frequency of a magnet motor on the basis of voltage command values and current detection values given to a power converter, electric circuit parameters of the magnet motor, and a frequency estimation value. Additionally, Patent Document 2 discloses a power conversion device for sensorless control of a permanent magnet motor that achieves stable control across both low and medium-high speed ranges, wherein the device computes two powers (first power from voltage/current, second power from circuit parameters/currents) and estimate phase error. Patent Document 3 discloses a vector control system for a permanent magnet synchronous motor that identifies motor constants (resistance R, inductances Ld/Lq, induced voltage coefficient Ke) without using a voltage detector, wherein the system operates in two modes: low-speed mode for resistance identification and medium/high-speed mode for inductance/voltage coefficient identification, and uses calculated active and reactive powers from current/voltage values to identify these parameters, which are then used to automatically adjust control parameters. Eventually, Patent Document 4 discloses a system for detecting abnormal operation in AC motor control without using sensors, wherein the system calculates motor constants (particularly power generation constant Ke) in real-time and monitors their variations to detect abnormalities like step-out or demagnetization.

PRIOR ART DOCUMENT

PATENT DOCUMENT

Patent Document 1: JP 4402600 B2
Patent Document 2: CN 116 830 450 A
Patent Document 3: US 2007/126 391 A1
Patent Document 4: US 11 273 712 B2

Other prior art document is EP 1 681 762 A2 which discloses the features of the preamble of claim 1.

SUMMARY OF THE INVENTION

The method described in Patent No. 4402600 includes computing two types of reactive powers (Q and Q^) and computing a frequency estimation value of an inverter such that the deviation $\Delta Q$ therebetween is zero. Since the frequency estimation value can reduce the sensitivity to the winding resistance value of the magnet motor, which change being due to a temperature change, highly-accurate control characteristics can be realized. A first motor frequency is estimated by proportional integral (PI) control by using a reactive power in the low speed range, and a second motor frequency is estimated by the PI control such that a phase error (between the phase of control and the phase of the magnet motor) directly estimated by using an extended induced voltage follows zero in the medium/high speed range. Therefore, when the first motor frequency and the second motor frequency are switched to each other, a torque shock due to a current change may occur if there is a difference between the two frequencies.

An object of the present invention is to provide a power conversion device capable of realizing stable and highly-accurate control of a magnet motor.

The invention is set out in the appended set of claims. Preferable embodiments are defined in the dependent claims.

According to the present invention, stable and highly-accurate control of a magnet motor can be realized. The problems, configurations, and effects other than those described above will be clarified by the following description of embodiments.

BRIEF DESCRIPTION OF THE DRAWINGS

FIG. 1 is a configuration diagram of a power conversion device according to an embodiment;
FIG. 2 is a configuration diagram of a phase error estimation computation unit in the high speed range where an extended induced voltage is used;
FIG. 3 is a configuration diagram of a phase error estimation computation unit in the low speed range according to the embodiment;
FIG. 4 is a configuration diagram of a frequency and phase estimation computation unit according to the embodiment;
FIG. 5 depicts control characteristics in the case where an extended induced voltage method in the medium/high speed range is used in the low speed range;
FIG. 6 depicts control characteristics in the case where the present invention is used in the low speed range;
FIG. 7 depicts control characteristics in the case where the present invention is used for switching between the low speed range and the medium/high speed range;
FIG. 8 is a configuration diagram for confirming the manifestation of the present invention;
FIG. 9 is a configuration diagram of a power conversion device according to another embodiment;
FIG. 10 is a configuration diagram of another phase error estimation computation unit in the low speed range according to the embodiment;
FIG. 11 is a configuration diagram of a power conversion device according to still another embodiment;
FIG. 12 is a configuration diagram of another phase error estimation computation unit in the high speed range according to the embodiment;
FIG. 13 is a configuration diagram of a power conversion device according to still another embodiment;
FIG. 14 is a configuration diagram of still another phase error estimation computation unit in the high speed range according to the embodiment;
FIG. 15 is a configuration diagram of another power conversion device according to the embodiment; and
FIG. 16 is a configuration diagram of still another power conversion device according to the embodiment.

DESCRIPTION OF THE PREFERRED EMBODIMENTS

In position sensorless control in which an encoder for detecting the magnet phase of a magnet motor and the like are omitted, the present embodiments realize stable and highly-accurate control characteristics even in a low speed range of, for example, approximately 10% of the base frequency from a stop. In the present embodiments, a phase error is estimated from the deviation between two types of reactive powers in the low speed range as is the case with the medium/high speed range. By estimating a motor frequency such that the estimation value of the relevant phase error follows the command value thereof, a torque shock is prevented and stable and highly-accurate control characteristics are realized without adjusting electric circuit parameters and control gains of the magnet motor set in a controller.

It should be noted that the present embodiments will be described below in detail by using the drawings. The same reference characters (signs) are given to the common configurations in each drawing. In addition, each embodiment to be described below is not limited to the illustrated examples.

First Embodiment

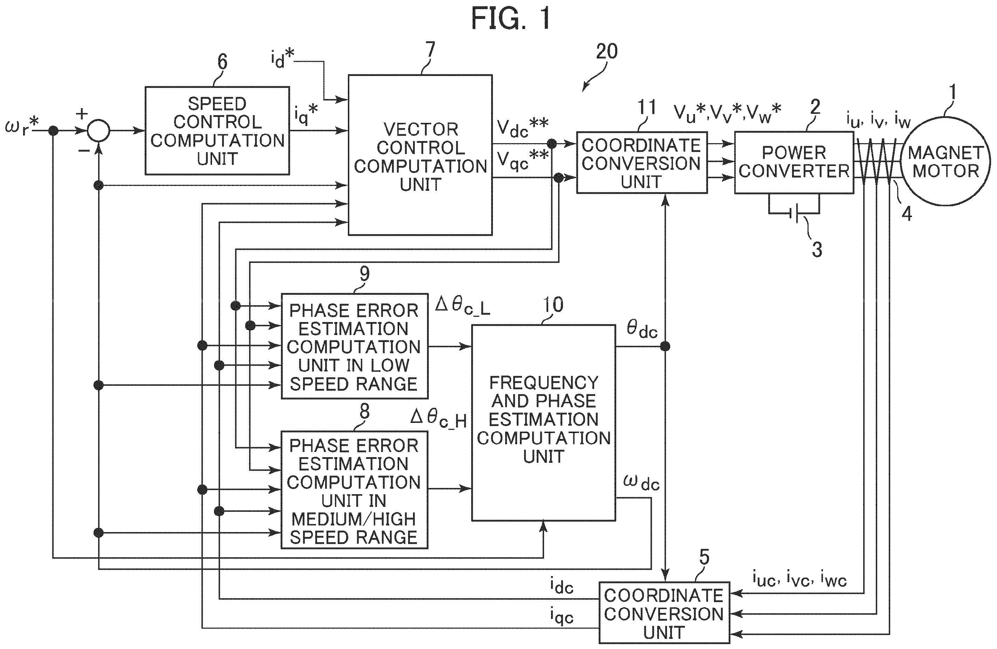

FIG. 1 depicts a configuration diagram of a power conversion device according to an embodiment.

A magnet motor 1 outputs a motor torque obtained by combining a torque component due to the magnetic flux of a permanent magnet and a torque component due to the inductance of an armature winding.

A power converter 2 outputs voltage values proportional to voltage command values $v_u{}^*$, $v_v{}^*$, and $v_w{}^*$ of three-phase AC, and varies an output voltage value and an output frequency value to the magnet motor 1. Although the power converter 2 of the present embodiment includes a controller (microcomputer or the like), a power conversion device 20 described later may include a controller. The controller is configured using a memory (storage device), a CPU (processor), an input/output circuit (communication device), and the like.

A DC power supply 3 supplies a DC voltage to the power converter 2.

A current detector 4 outputs $i_{uc}$, $i_{vc}$, and $i_{wc}$ that are the detection values of three-phase AC currents $i_u$, $i_v$, and $i_w$ of the magnet motor 1. In addition, the current detector 4 detects the AC currents of two phases among the three phases of the magnet motor 1, which are the u phase and the w phase, for example, and the AC current of the v phase may be obtained from the AC condition ($i_u + i_v + i_w = 0$) as $i_v = - (i_u + i_w)$.

A coordinate conversion unit 5 outputs current detection values $i_{dc}$ and $i_{qc}$ of the d axis and the q axis from the detection values $i_{uc}$, $i_{vc}$, and $i_{wc}$ of the three-phase AC currents $i_u$, $i_v$, and $i_w$ and a phase estimation value $\theta_{dc}$.

A speed control computation unit 6 computes a torque command value t* on the basis of a frequency command value $\omega_r$* and a frequency estimation value $\omega_{dc}$, and divides it by a torque coefficient, so that a current command value $i_q$* of the q axis is output.

A vector control computation unit 7 outputs voltage command values $v_{dc}$** and $v_{qc}$** of the d axis and the q axis computed on the basis of the current command values $i_d$* and $i_q$* and the current detection values $i_{dc}$ and $i_{qc}$ of the d axis and the q axis, the frequency estimation value $\omega_{dc}$, and electric circuit parameters of the magnet motor 1.

A phase error estimation computation unit 8 in the medium/high speed range outputs an estimation value $\Delta\theta_{c\_H}$ of a phase error $\Delta\theta$, which is the deviation between the phase $\theta_{dc}$ of control and the phase $\theta_d$ of the magnet of the magnet motor 1 in the medium/high speed range, by using voltage command values $v_{dc}$** and $v_{qc}$** of the $d_c$ axis and the $q_c$ axis that are the control axes, the frequency estimation value $\omega_{dc}$, the current detection values $i_{dc}$ and $i_{qc}$, and the electric circuit parameters of the magnet motor 1.

A phase error estimation computation unit 9 in the low speed range computes an estimation value $\Delta\theta_{c\_L}$ of the phase error $\Delta\theta$, which is the deviation between the phase $\theta_{dc}$ of control and the phase $\theta_d$ of the magnet of the magnet motor 1 in the low speed range, by using the voltage command values $v_{dc}$** and $v_{qc}$** of the $d_c$ axis and the $q_c$ axis that are the control axes, the frequency estimation value $\omega_{dc}$, the current detection values $i_{dc}$ and $i_{qc}$, and the electric circuit parameters of the magnet motor 1.

A frequency and phase estimation computation unit 10 outputs the frequency estimation value $\omega_{dc}$ and the phase estimation value $\theta_{dc}$ on the basis of the estimation value $\Delta\theta_{c\_L}$ of the phase error in the low speed range or the estimation value $\Delta\theta_{c\_H}$ of the phase error in the medium/high speed range.

A coordinate conversion unit 11 outputs the voltage command values $v_{dc}$** and $v_{qc}$** of the $d_c$ axis and the $q_c$ axis and the voltage command values $v_u$*, $v_v$*, and $v_w$* of the three-phase AC from the phase estimation value $\theta_{dc}$.

First, the basic operation of a sensorless vector control system in the case where the phase error estimation computation unit 9 in the low speed range, which is a feature of the present embodiment, is used will be described.

The speed control computation unit 6 computes the torque command t* and the current command value $i_q$* of the q axis in accordance with Equation (1) by proportional control and integral control such that a frequency estimation value $\omega_r$^ ($=\omega_{dc}$) follows the frequency command value $\omega_r$*. It should be noted that in the following various equations, the frequency estimation value will be described as $\omega_r$^ or $\omega_{dc}$ in some cases.

[Equation 1]

$$\left. \begin{array}{l} \tau^* = \left(\omega_r^* - \omega_r^\wedge\right)\left(K_{sp} + \dfrac{K_{si}}{s}\right) \\[4mm] i_q^* = \dfrac{\tau^*}{3/2\,P_m\left[K_e^* + (L_d^* - L_q^*)i_d^*\right]} \end{array} \right\} \quad \cdots (1)$$

Here, $K_{sp}$ is a proportional gain of speed control, $K_{si}$ is an integral gain of speed control, $P_m$ is the number of pole pairs, $K_e$ is an induced voltage coefficient, $L_d$ is a d-axis inductance, $L_q$ is a q-axis inductance, and * is a set value.

First, the vector control computation unit 7 outputs voltage reference values $v_{dc}$* and $v_{qc}$* of the $d_c$ axis and the $q_c$ axis in accordance with Equation (2) by using a set value R* of the winding resistance that is an electric circuit parameter of the magnet motor 1, a set value $L_d$* of the d-axis inductance, a set value $L_q$* of the q-axis inductance, a value $K_e$* of the induced voltage coefficient, the current command values $i_d$* and $i_q$* of the $d_c$ axis and the $q_c$ axis, and the frequency estimation value $\omega_r$^ ($=\omega_{dc}$).

[Equation 2]

$$\left[ \begin{array}{l} v_{dc}^* = R^* i_d^* - \omega_{dc} L_q^* \dfrac{1}{1 + T_{acr}\,s} i_q^* \\[4mm] v_{qc}^* = R^* i_q^* + \omega_{dc}\left(L_d^* \dfrac{1}{1 + T_{acr}\,s} i_d^* + K_e^*\right) \end{array} \right] \quad \cdots (2)$$

Here, $T_{acr}$ is a response time constant of current control.

Second, the vector control computation unit 7 computes voltage correction values $\Delta v_{dc}$ and $\Delta v_{qc}$ of the $d_c$ axis and the $q_c$ axis in accordance with Equation (3) by proportional control and integral control such that the current detection values $i_{dc}$ and $i_{qc}$ of each component follow the current command values $i_d$* and $i_q$* of the $d_c$ axis and the $q_c$ axis.

[Equation 3]

$$\begin{bmatrix} \Delta v_{dc} = \left( K_{pd} + \dfrac{K_{id}}{s} \right)(i_d{}^* - i_{dc}) \\[2mm] \Delta v_{qc} = \left( K_{pq} + \dfrac{K_{iq}}{s} \right)(i_q{}^* - i_{qc}) \end{bmatrix} \quad \cdots (3)$$

Here, $K_{pd}$ is a proportional gain of current control of the $d_c$ axis, $K_{id}$ is an integral gain of current control of the $d_c$ axis, $K_{pq}$ is a proportional gain of current control of the $q_c$ axis, and $K_{iq}$ is an integral gain of current control of the $q_c$ axis. The vector control computation unit 7 further computes the voltage command values $v_{dc}{}^{**}$ and $v_{qc}{}^{**}$ of the $d_c$ axis and the $q_c$ axis in accordance with Equation (4).

[Equation 4]

$$\begin{bmatrix} v_{dc}{}^{**} = v_{dc}{}^* + \Delta v_{dc} \\[2mm] v_{qc}{}^{**} = v_{qc}{}^* + \Delta v_{qc} \end{bmatrix} \quad \cdots (4)$$

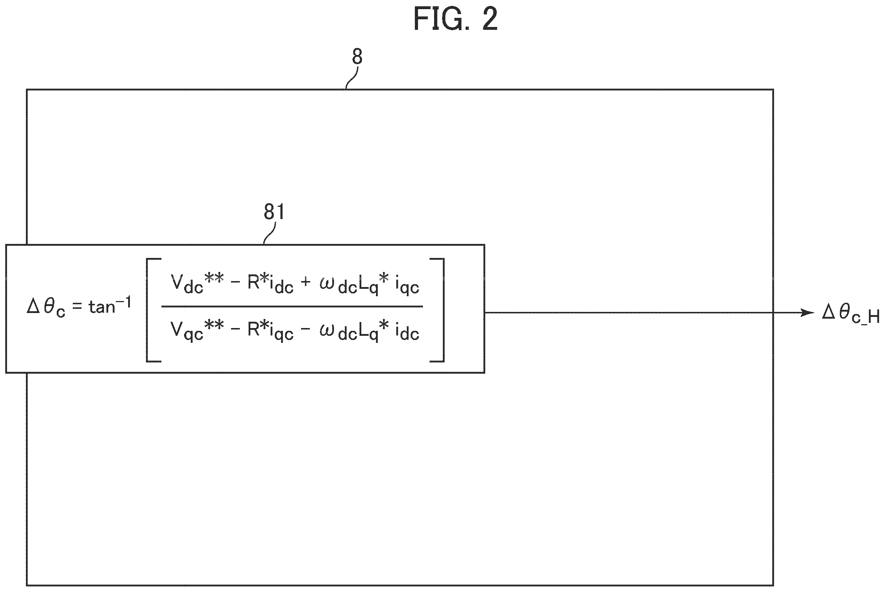

FIG. 2 depicts a block of the phase error estimation computation unit 8 in the medium/high speed range. The phase error estimation computation unit 8 in the medium/high speed range computes the estimation value $\Delta\theta_{c\_H}$ of the phase error in the medium/high speed range in accordance with Equation (5) of an extended induced voltage denoted by the reference numeral 81, on the basis of the voltage command values $v_{dc}{}^{**}$ and $v_{qc}{}^{**}$ and the current detection values $i_{dc}$ and $i_{qc}$ of the $d_c$ axis and the $q_c$ axis, and the electric circuit parameters ($R^*$ and $L_q{}^*$) of the magnet motor 1.

[Equation 5]

$$\Delta\theta_{c\_H} = \tan^{-1}\left( \frac{v_{dc}{}^{**} - R^* i_{dc} + \omega_{dc} L_q{}^* i_{qc}}{v_{qc}{}^{**} - R^* i_{qc} - \omega_{dc} L_q{}^* i_{dc}} \right) \quad \cdots (5)$$

Here, the phase error estimation computation unit 9 in the low speed range, which is a feature of the present embodiment of the present invention, will be described.

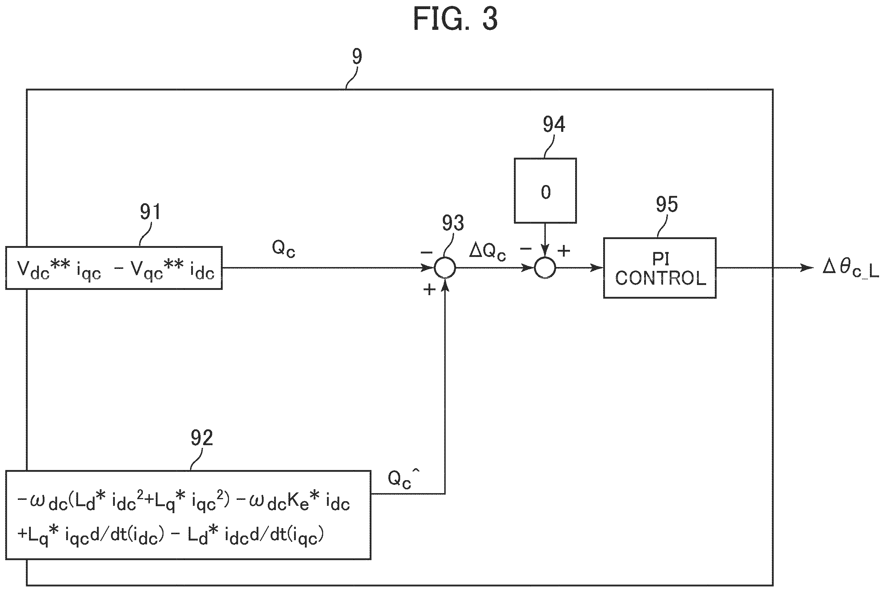

FIG. 3 depicts a block of the phase error estimation computation unit 9 in the low speed range. The phase error estimation computation unit 9 in the low speed range computes a first reactive power $Q_c$ in accordance with Equation (6) by using the voltage command values $v_{dc}{}^{**}$ and $v_{qc}{}^{**}$ and the current detection values $i_{dc}$ and $i_{qc}$ of the $d_c$ axis and the $q_c$ axis in a first reactive power computation unit 91.

[Equation 6]

$$Q_c = v_{dc}{}^{**} i_{qc} - v_{qc}{}^{**} i_{dc} \quad \cdots (6)$$

A second reactive power computation unit 92 computes a second reactive power $Q_c{}^\wedge$ in accordance with Equation (7) by using steady components $i_{dc}$ and $i_{qc}$ and transient components $dt/d(i_{dc})$ and $dt/d(i_{qc})$ of the current detection values of the $d_c$ axis and the $q_c$ axis, the frequency estimation value $\omega_{dc}$, and the electric circuit parameters ($L_d{}^*$, $L_q{}^*$, and $K_e{}^*$) of the magnet motor 1.

[Equation 7]

$$Q_c{}^\wedge = -\omega_{dc}\left( L_d{}^* i_{dc}{}^2 + L_q{}^* i_{qc}{}^2 \right) - \omega_{dc} K_e{}^* \\ + L_d{}^* i_{dc} + L_d{}^* i_{qc}\, d/dt(i_{dc}) - L_q{}^* i_{dc}\, d/dt(i_{qc}) \quad \cdots (7)$$

A subtraction unit 93 receives inputs of the first reactive power $Q_c$ and the second reactive power $Q_c{}^\wedge$, and computes $\Delta Q_c$ as the deviation therebetween. The deviation $\Delta Q_c$ between the reactive powers is input to a PI control computation unit 95 so as to follow "0" that is a command value 94 thereof, and the estimation value $\Delta\theta_{c\_L}$ of the phase error $\Delta\theta$ in the low speed range is computed in accordance with Equation (8) by proportional (P) + integral (I) control computation.

[Equation 8]

$$\Delta\theta_{c\_L} = \left( K_{p\theta} + \frac{K_{i\theta}}{s} \right)(0 - \Delta Q_c) \quad \cdots (8)$$

Here, $K_{p\theta}$ is a proportional gain of phase error estimation computation, and $K_{i\theta}$ is an integral gain of phase error estimation computation.

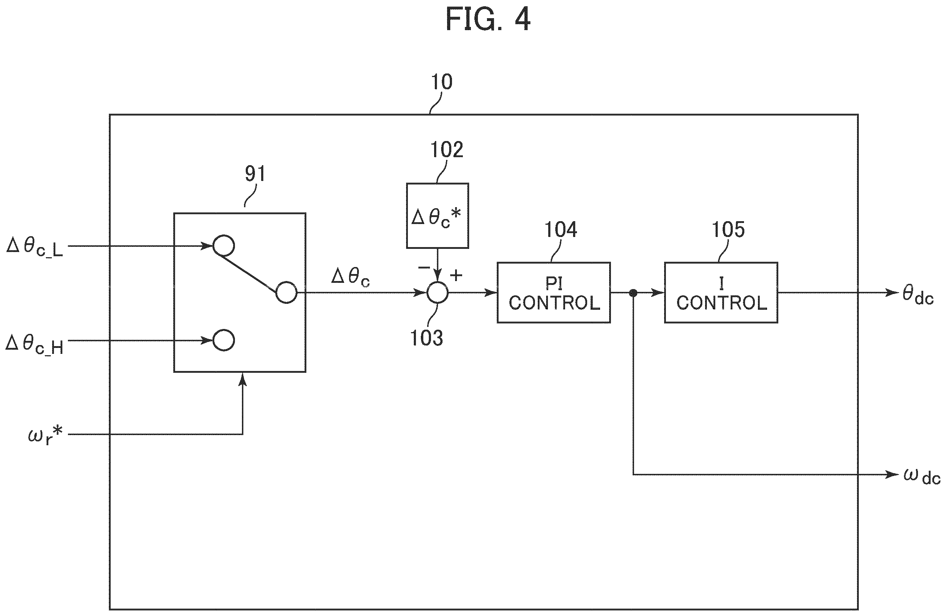

In addition, the frequency and phase estimation computation unit 10, which is a feature of the embodiment of the present invention, will be described. FIG. 4 depicts a block of the frequency and phase estimation computation unit 10.

A switching unit 101 receives inputs of the estimation value $\Delta\theta_{c\_L}$ of the phase error in the low speed range, the estimation value $\Delta\theta_{c\_H}$ of the phase error in the medium/high speed range, and the frequency command value $\omega_r^*$, and outputs $\Delta\theta_c = \Delta\theta_{c\_L}$ in the case of the low speed range and $\Delta\theta_c = \Delta\theta_{c\_H}$ in the case of the medium/high speed range, as the estimation value $\Delta\theta_c$ of the phase error according to the magnitude of the frequency command value $\omega_r^*$.

The subtraction unit 103 inputs the estimation value $\Delta\theta_c$ of the phase error described above to the PI control computation unit 104 so as to follow the command value $\Delta\theta_c^*$ denoted by the reference numeral 102, the frequency estimation value $\omega_{dc}$ is computed in accordance with Equation (9) by the proportional (P) + integral (I) computation, and the phase estimation value $\theta_{dc}$ is computed in accordance with Equation (10) by an I control computation unit 105.

[Equation 9]

$$\omega_{dc} = \left( Kp_{pll} + \frac{Ki_{pll}}{s} \right)(\Delta\theta_c^* - \Delta\theta_c) \quad \cdots (9)$$

[Equation 10]

$$\theta dc = \frac{1}{s} \cdot \omega_{dc} \quad \cdots (10)$$

Here, $K_{ppll}$ is a proportional gain of PLL control, and $Ki_{pll}$ is an integral gain of PLL control.

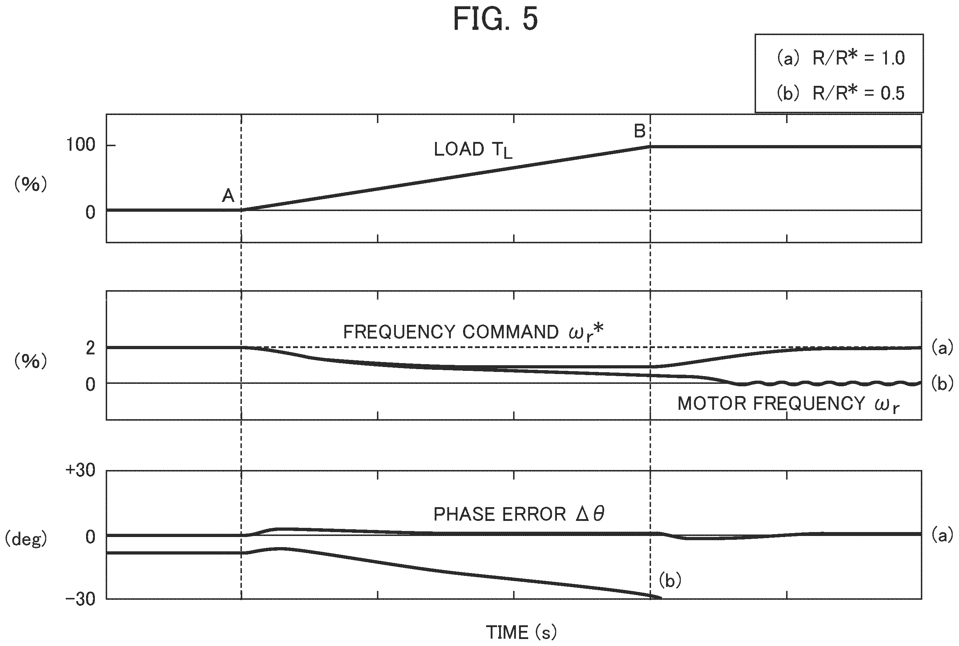

Next, the principle in which the embodiment of the present invention provides stable and highly-accurate control characteristics will be described. FIG. 5 depicts control characteristics in the case where the phase error estimation computation unit 9 in the low speed range of the present invention is not used ($\Delta\theta_{c\_H}$ is used). The frequency command value $\omega_r^*$ is set to 2% of the base frequency. FIG. 5 depicts simulation results of (a) R*/R=1 (reference) when there is no error and (b) R*/R=0.5 when there is an error, in the voltage command values $v_{dc}^{**}$ and $v_{dc}^{**}$ of the $d_c$ axis and the $q_c$ axis depicted in Equation (2) and the set value R* of the resistance value R included in the computation formula of the phase error in the medium/high speed range depicted in Equation (5).

In the drawing, the upper row indicates a load torque $\tau L$, the middle row indicates a frequency command $\omega_r^*$ and a motor frequency $\omega_r$, and the lower row indicates a phase error $\Delta\theta$. In the drawing, the load torque application that starts with the point A of the time is changed in a ramp-like manner to reach 100% at the point B of the time, and then the load torque application state is kept as it is on the right side of the point B.

In the setting of (a) R*/R=1 (reference), the phase error $\Delta\theta$ is zero in the steady state, and the motor frequency $\omega_r$ matches the frequency command $\omega_r^*$. In the setting of (b) R*/R=0.5, the phase error $\Delta\theta$ increases to "negative," the motor frequency $\omega_r$ is stagnant around zero, and the magnet motor 1 is stepped out.

In the embodiment of the present invention, the first reactive power $Q_c$ is computed in accordance with Equation (6) by using the voltage command values $v_{dc}^*$ and $v_{qc}^*$ and the current detection values $i_{dc}$ and $i_{qc}$ of the $d_c$ axis and the $q_c$ axis, and the second reactive power $Q_c\wedge$ is computed in accordance with Equation (7) by using the steady components $i_{dc}$ and iqc and the transient components $dt/d(i_{dc})$ and $dt/d(i_{qc})$ of the current detection values of the $d_c$ axis and the $q_c$ axis, the frequency estimation value $\omega_{dc}$, and the set values ($L_d^*$, $L_q^*$, and $K_e^*$) of the electric circuit parameters of the magnet motor 1. By automatically adjusting the estimation value $\Delta\theta_{c\_L}$ of the phase error in the low speed range in accordance with Equation (8) such that the deviation between $Q_c\wedge$ and $Q_c$ follows zero, and by using the estimation value $\Delta\theta_{c\_L}$ in the frequency and phase estimation computation unit 10, the sensitivity to the resistance value can be reduced and the control characteristics can be improved.

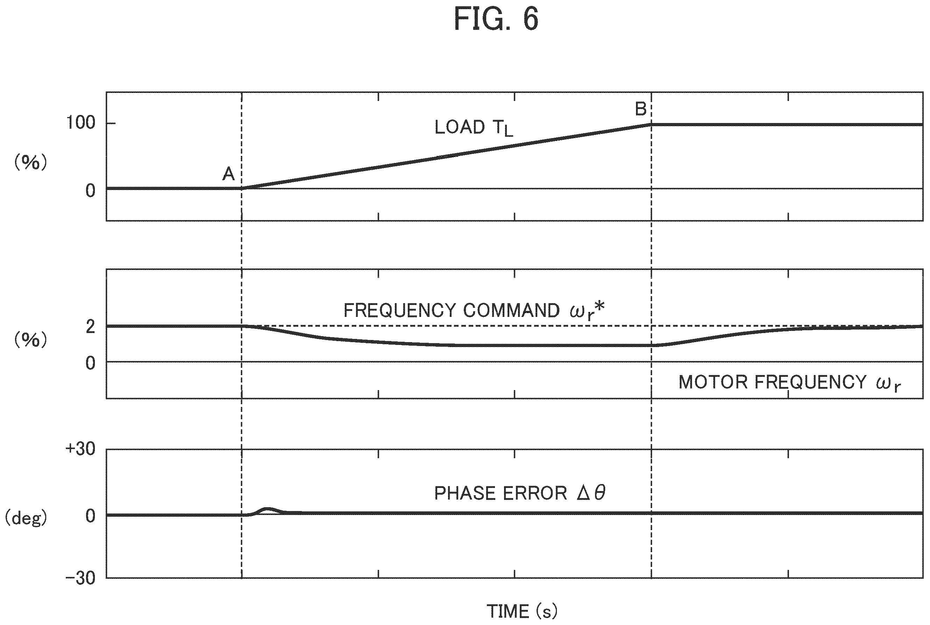

FIG. 6 depicts control characteristics in the low speed range according to the present embodiment. In the setting of R*/R=0.5, the phase error estimation computation unit 9 in the low speed range and the frequency and phase estimation computation unit 10 are operated to apply the load torque similar to that in FIG. 4. Since the estimation value $\Delta\theta_{c\_L}$ of the phase error is computed from the reactive power that is less sensitive to the resistance value R, the actual phase error $\Delta\theta$ can be suppressed to zero even in the setting of R*/R=0.5.

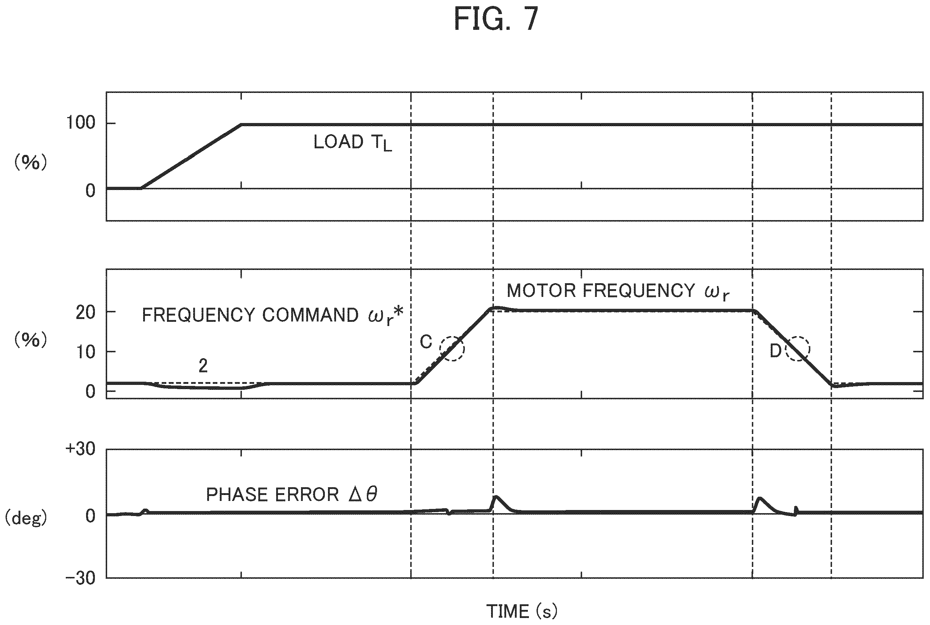

Further, FIG. 7 depicts control characteristics in which the frequency command value $\omega_r^*$ is accelerated from 2% to 20% of the base frequency and decelerated from 20% to 2% by using the present invention. At this time, $\omega_r^*$ is 10% in

magnitude, and the estimation value of the phase error is switched between the low speed range and the medium/high speed range. The estimation value of the phase error is computed in accordance with Equations (6) to (8) in the low speed range where $\omega_r^*$ is less than 10%, and is computed in accordance with Equation (5) in the medium/high speed range where $\omega_r^*$ is equal to or more than 10%.

The speed is switched from the low speed range to the medium/high speed range in the region C of the drawing, and the speed is switched from the medium/high speed range to the low speed range in the region D. Viewing the phase error $\Delta\theta$ in the lower row, it can be understood that there is no shock in the motor frequency $\omega_r$ although the magnitude slightly changes at the switching timing, and the effect of the embodiment of the present invention is obvious.

In the present embodiment, as an example, $\omega_r^*$ is 10% in magnitude, and the estimation value of the phase error is switched between the low speed range and the medium/high speed range, but there is no problem even if the value is 0 or more and 10% or less. In addition, the estimation value $\Delta\theta_{c\_L}$ of the phase error in the low speed range is multiplied by a taper gain $G_L$ that changes between "1" and "0", and the estimation value $\Delta\theta_{c\_H}$ of the phase error in the medium/high speed range is multiplied by a taper gain $G_H$ that changes between "0" and "1", so that the average value of the estimation values of the phase error may be $\Delta\theta_c$.

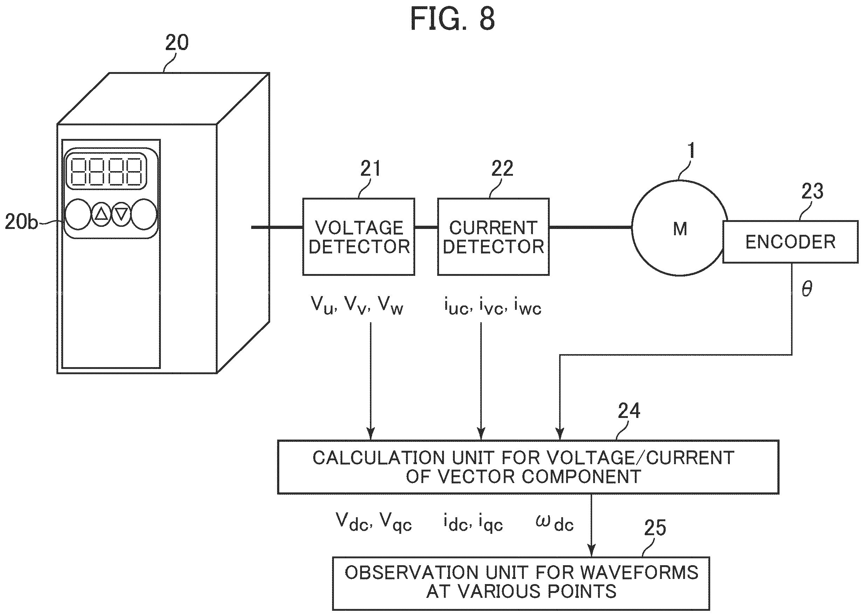

Here, a verification method in the case where the present embodiment is adopted will be described by using FIG. 8. A voltage detector 21 and a current detector 22 are attached to the power conversion device 20 that drives the magnet motor 1, and an encoder 23 is attached to the shaft of the magnet motor 1. It should be noted that the power conversion device 20 includes the power converter 2, a digital operator 20b (user interface serving as an input device and a display device), and the like.

The voltage detection values ($v_{uc}$, $v_{vc}$, and $v_{wc}$) of the three-phase AC, which are the outputs of the voltage detector 21, the current detection values ($i_{uc}$, $i_{vc}$, and $i_{wc}$) of the three-phase AC, and the position $\theta$, which is the output of the encoder, are input to a calculation unit 24 for voltage/current of the vector component, and a detection value $\omega_{rc}$ is computed, which is obtained by differentiating the vector voltage components $v_{dc}$ and $v_{qc}$, the vector current components $i_{dc}$ and $i_{qc}$, and the position $\theta$.

A phase error $\Delta\theta_{\_cal}$ is computed by using Equation (11) in an observation unit 25 for waveforms at various points.
[Equation 11]

$$
\left.
\begin{aligned}
\Delta\theta\_cal &= \frac{-b \pm \sqrt{b^2 - 4ac}}{2a} \\[1em]
a &= \left(L_d - L_q\right)\left(i_{qc}^2 - i_{dc}^2\right) \\
b &= \left(2\left(L_d - L_q\right)i_{dc}^2 + K_e\right)i_{qc} \\
c &= -\left(L_q^* - L_q\right)i_{qc}^2 - \left(L_d^* - L_d\right)i_{dc}^2 - \left(K_e^* - K_e\right)i_{dc}
\end{aligned}
\right\} \quad \cdots (11)
$$

It is obvious that the present invention has been adopted if $\Delta\theta_{\_cal}$ in Equation (11), which is computed by changing the magnitudes of the parameters ($R^*$, $L_d^*$, $L_q^*$, and $K_e^*$) set in the controller of the power converter 2, matches the actual phase error $\Delta\theta$.

The main features of the first embodiment can also be summarized as follows.

As depicted in FIG. 3, the processor of the power conversion device 20 computes the first power (first reactive power $Q_c$) from the voltages (voltage command values $v_{dc}^{**}$ and $v_{qc}^{**}$) and the currents (current detection values $i_{dc}$ and $i_{qc}$) of the magnet motor 1 (Equation (6)). The processor computes the second power (second reactive power $Q_c^\wedge$) from the electric circuit parameters ($L_d^*$, $L_q^*$, and $K_e^*$) of the magnet motor 1, the steady components (current detection values $i_{dc}$ and $i_{qc}$) and the transient components $dt/d(i_{dc})$ and $dt/d(i_{qc})$ of the current of the magnet motor 1, and the frequency estimation value $\omega_{dc}$ of the magnet motor 1 (Equation (7)). The processor estimates the phase deviation (phase error $\Delta\theta$) indicating the deviation (difference) between the phase $\theta_{dc}$ of control and the phase (phase $\theta_d$ of the magnet) of the magnetic flux of the magnet motor such that the first power follows the second power. As depicted in FIG. 4, the processor computes the frequency estimation value $\omega_{dc}$ from the estimation values ($\Delta\theta_{c\_L}$ and $\Delta\theta_{c\_H}$) of the phase deviation. In the present embodiment, the first power and the second power are reactive powers.

Since the second power includes the transient components of the current of the magnet motor 1, the accuracy of the phase deviation (phase error $\Delta\theta$) and the frequency estimation value $\omega_{dc}$ is secured even when the frequency of the magnet motor 1 is switched. Accordingly, stable and highly-accurate control characteristics can be realized without adjusting the electric circuit parameters and the control gains of the magnet motor 1. In addition, even if the responsiveness of the speed control is enhanced, the oscillation of the current (q-axis current) when the frequency of the magnet motor 1 is switched is suppressed. Accordingly, a torque shock can be suppressed. Since the first power and the second power do not include the winding resistance value, the deterioration of the accuracy of the phase deviation (phase error $\Delta\theta$) and the

frequency estimation value $\omega_{dc}$ due to a change in the winding resistance value accompanying a temperature change in the low speed range is suppressed. Accordingly, highly-accurate control of the magnet motor 1 can be realized regardless of the temperature change.

More specifically, as depicted in FIG. 3, the processor computes the first power (first reactive power $Q_c$) from the difference ($v_{dc}$**$i_{qc}$ - $v_{qc}$**$i_{dc}$) between the products of the voltage command values and the current detection values of the different components of the d axis, which is the magnetic flux axis of the magnet motor 1, and the q axis, which is the torque axis of the magnet motor 1. The processor computes the second power (second reactive power $Q_c$^) from the electrical circuit parameters ($L_d$*, $L_q$*, and $K_e$*), the steady components (current detection values $i_{dc}$ and $i_{qc}$) and the transient components dt/d($i_{dc}$) and dt/d($i_{qc}$) of the current detection values or the current command values of the d axis and the q axis, and the frequency estimation value $\omega_{dc}$. Accordingly, stable and highly-accurate control of the magnet motor 1 can be realized in the power conversion device of the vector control.

In the present embodiment, the processor computes the estimation value $\Delta\theta_{c\_L}$ of the phase deviation (phase error $\Delta\theta$) by performing proportional control and integral control such that the power deviation (deviation $\Delta Q_c$ between the reactive powers) indicating the deviation between the first power (first reactive power $Q_c$) and the second power (second reactive power $Q_c$^) is zero. Accordingly, the estimation value $\Delta\theta_{c\_L}$ of the phase deviation (phase error $\Delta\theta$) can be computed on the basis of the power deviation.

As depicted in FIG. 3, the processor computes the estimation value $\Delta\theta_{c\_L}$ of the phase deviation by performing proportional control and integral control such that the power deviation (deviation $\Delta\bar{Q}_c$) between the reactive powers is zero in the low speed range where the frequency command value $\omega_r$* is less than a threshold value. As depicted in FIG. 2, the processor computes the estimation value $\Delta\theta_{c\_H}$ of the phase deviation by using an extended induced voltage method in the medium/high speed range where the frequency command value $\omega_r$* is equal to or larger than a threshold value. Accordingly, stable and highly-accurate control of the magnet motor 1 can be realized in all the speed ranges.

Second Embodiment

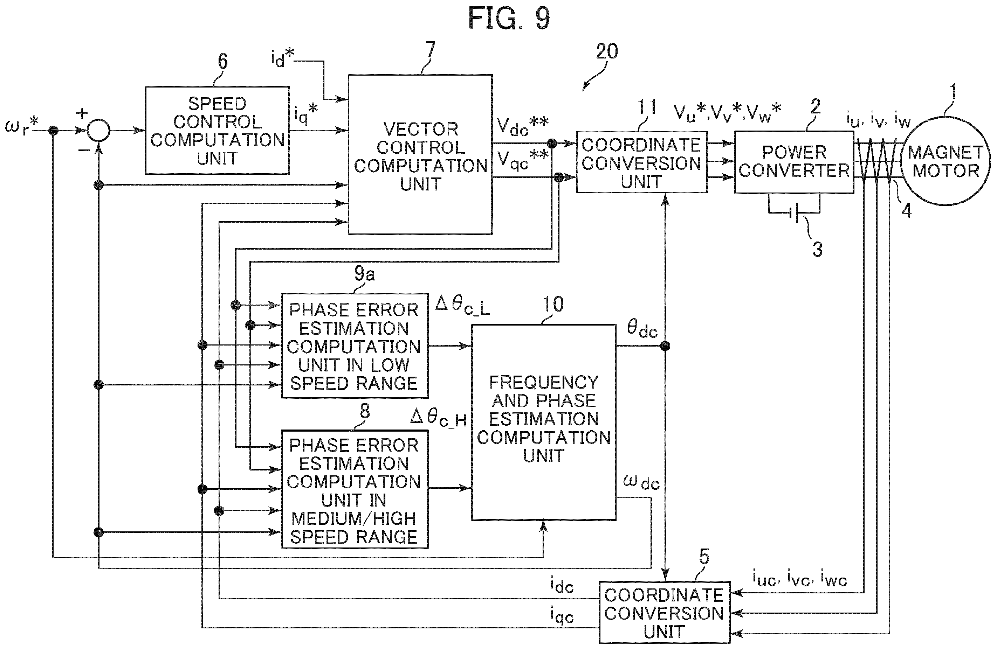

FIG. 9 is a configuration diagram of a power conversion device according to an embodiment.

In the first embodiment, the phase error estimation computation unit 9 in the low speed range computes the first reactive power $Q_c$ from the voltage command values $v_{dc}$** and $v_{qc}$** and the current detection values $i_{dc}$ and $i_{qc}$ of the $d_c$ axis and the qc axis, but in the present embodiment, the first reactive power $Q_c$ is computed by using an amplitude value $V_1$* of the voltage command of the three-phase AC, an amplitude value $i_1$ of the current detection value, and a sine signal of a phase $\theta_{vi}$. The reference numerals 1 to 8, 10, and 11 in the drawing are the same as those in FIG. 1.

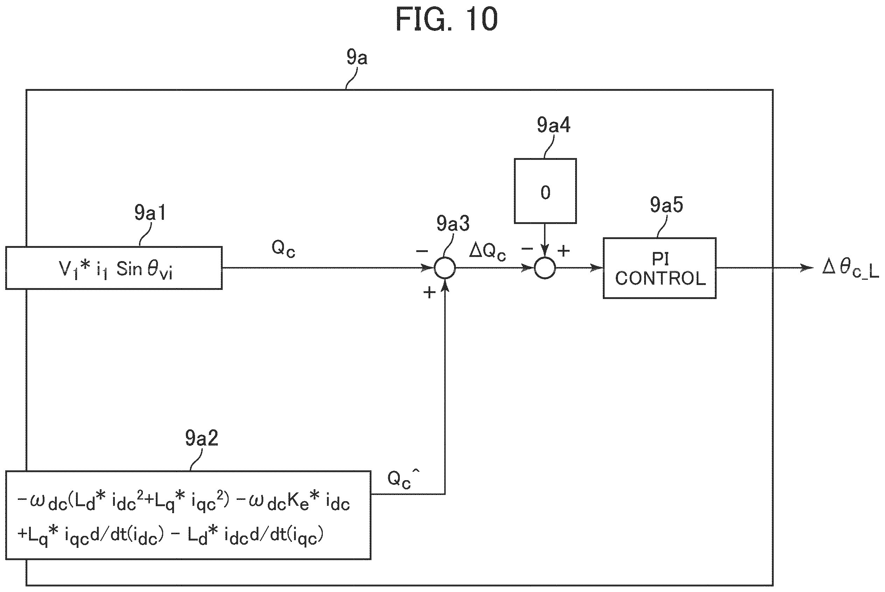

FIG. 10 is a configuration diagram of a phase error estimation computation unit 9a in the low speed range of the embodiment of the present invention. The reference numeral 9a of the drawing corresponds to the reference numeral 9 in FIG. 1. In addition, the reference numerals 9a2, 9a3, 9a4, and 9a5 in FIG. 10 are the same as the reference numerals 92, 93, 94, and 95 in FIG. 3, respectively. In the drawing, in 9a1, the amplitude value $V_1$* of the voltage command of the three-phase AC is obtained in accordance with Equation (12), the amplitude value $i_1$ of the current detection value is obtained in accordance with Equation (13), the phase $\theta_{vi}$ is obtained in accordance with Equation (14), and the reactive power $Q_c$ is computed by using Equation (15).

[Equation 12]

$$v_1^* = \sqrt{v_{dc}^{**2} + v_{qc}^{**2}} \qquad \cdots (12)$$

[Equation 13]

$$i_1 = \sqrt{i_{dc}^2 + i_{qc}^2} \qquad \cdots (13)$$

[Equation 14]

$$\theta_{vi} = \tan^{-1}\left[-\frac{v_{dc}}{v_{qc}}\right] + \tan^{-1}\left[-\frac{i_{dc}}{i_{qc}}\right] \qquad \cdots (14)$$

[Equation 15]

$$Q_c = v_1^{*} \, i_1 \sin [\theta_{vi}] \quad \cdots (15)$$

Even if the present embodiment is used, highly-accurate control characteristics can be realized as similar to the first embodiment.

The main features of the second embodiment can also be summarized as follows.

As depicted in FIG. 10, the processor of the power conversion device 20 computes the first power (first reactive power $Q_c$) from the product of the voltage amplitude value (amplitude value $V_1^{*}$ of the voltage command) of one phase of the three-phase AC, the current amplitude value (amplitude value $i_1$ of the current detection value) of the phase, and the sine signal sin $[\theta_{vi}]$ of the phase difference between the voltage command value and the current detection value of the phase (Equation (15)). The processor computes the second power (second reactive power $Q_c^{\wedge}$) from the electrical circuit parameters ($L_d^{*}$, $L_q^{*}$, and $K_e^{*}$), the steady components (current detection values $i_{dc}$ and $i_{qc}$) and the transient components dt/d($i_{dc}$) and dt/d($i_{qc}$) of the current detection values or the current command values of the d axis and the q axis, and the frequency estimation value $\omega_{dc}$. Stable and highly-accurate control of the magnet motor 1 can be realized on the basis of the sine signal of the three-phase AC.

Third Embodiment

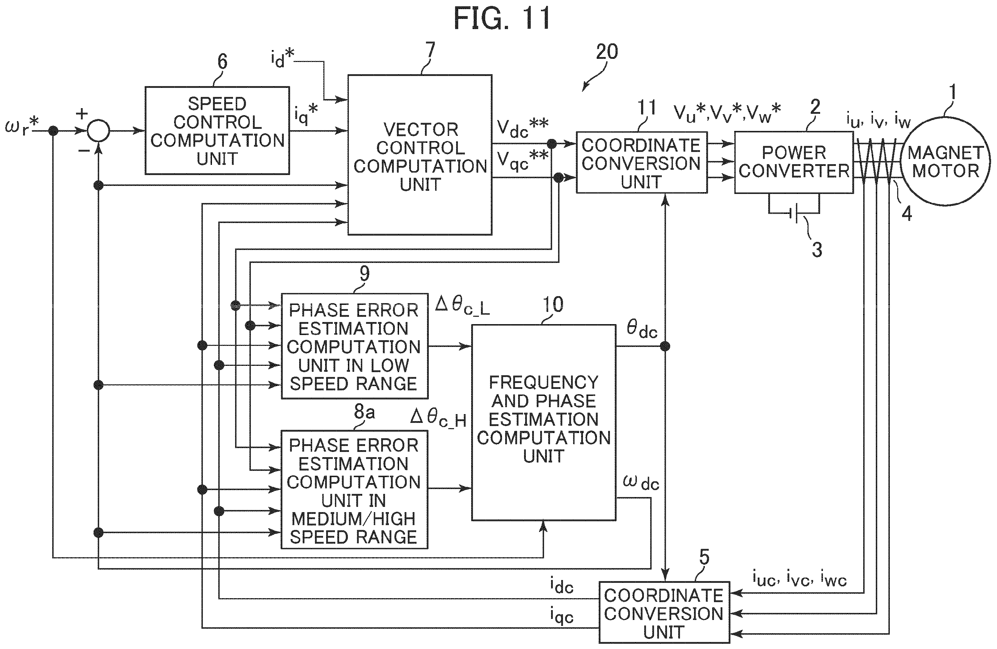

FIG. 11 is a configuration diagram of a power conversion device according to an embodiment.

In the first embodiment, the phase error estimation computation unit 8 in the medium/high speed range computes the estimation value $\Delta\theta_{c\_H}$ of the phase error in the medium/high speed range in accordance with Equation (5), but in the third embodiment, a first active power $P_c$ is computed from the voltage command values $v_{dc}^{**}$ and $v_{qc}^{**}$ and the current detection values $i_{dc}$ and $i_{qc}$ of the $d_c$ axis and the $q_c$ axis.

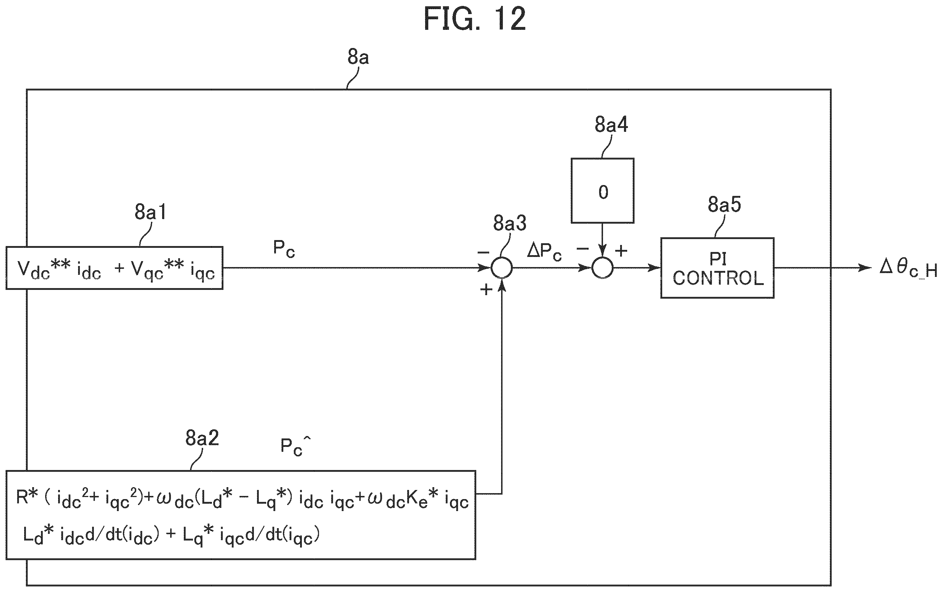

FIG. 12 is a phase error estimation computation unit 8a in the medium/high speed range of the embodiment of the present invention. The reference numeral 8a of the drawing corresponds to the reference numeral 8 in FIG. 1. The reference numerals 1 to 7 and 9 to 11 in the drawing are the same as those in FIG. 1.

In the phase error estimation computation unit 8a of the drawing, a first active power computation unit 8a1 computes the first reactive power $P_c$ in accordance with Equation (16) by using the voltage command values $v_{dc}^{**}$ and $v_{qc}^{**}$ and the current detection values $i_{dc}$ and $i_{qc}$ of the $d_c$ axis and the $q_c$ axis.

[Equation 16]

$$P_c = v_{dc}^{**} \, i_{dc} + v_{qc}^{**} \, i_{qc} \quad \cdots (16)$$

A second active power computation unit 8a2 computes a second active power $P_c^{\wedge}$ in accordance with Equation (17) by using the steady components $i_{dc}$ and $i_{qc}$ and the transient components dt/d($i_{dc}$) and dt/d($i_{qc}$) of the current detection values of the $d_c$ axis and the $q_c$ axis, the frequency estimation value $\omega_{dc}$, and the electric circuit parameters ($R^{*}$, $L_d^{*}$, $L_q^{*}$, and $K_e^{*}$) of the magnet motor 1.

[Equation 17]

$$P_c^{\wedge} = R^{*}( i_{dc}^2 + i_{qc}^2 ) + d/dt(i_{dc})L_d^{*} \, i_{dc} + d/dt(i_{qc})L_q^{*} \, i_{qc}$$
$$+ \omega_{dc}(L_d^{*} - L_q^{*})i_{dc} \, i_{qc} + \omega_{dc} \, K_e^{*} \, i_{qc} \quad \cdots (17)$$

A subtraction unit 8a3 receives inputs of the first active power $P_c$ and the second active power $P_c^{\wedge}$, and computes $\Delta P_c$ as the deviation therebetween. The deviation $\Delta P_c$ between the active powers is input to a PI control computation unit 8a5 so as to follow "0" that is a command value 8a4 thereof, and the estimation value $\Delta\theta_{c\_H}$ of the phase error $\Delta\theta$ in the high speed range is computed in accordance with Equation (18) by P (proportional) + I (integral) control.

[Equation 18]

$$\Delta\theta_{c\_H} = \left( K_{p\theta} + \frac{K_{i\theta}}{s} \right)(0 - \Delta P_c) \quad \cdots (18)$$

Here, $K_{p\theta}$ is a proportional gain of phase error estimation computation, and $K_{i\theta}$ is an integral gain of phase error estimation computation.

The main features of the third embodiment can also be summarized as follows.

As depicted in FIG. 12, the processor of the power conversion device 20 computes the first power (first active power $P_c$) from the sum ($v_{dc}^{**}i_{qc} + v_{qc}^{**}i_{dc}$) of the products of the voltage command values and the current detection values of the same component of the d axis, which is the magnetic flux axis of the magnet motor 1, and the q axis, which is the torque axis of the magnet motor 1 (Equation (16)). The processor computes the second power (second active power $P_c^\wedge$) from the electrical circuit parameters ($R^*$, $L_d^*$, $L_q^*$, and $K_e^*$), the steady components (current detection values $i_{dc}$ and $i_{qc}$) and the transient components $dt/d(i_{dc})$ and $dt/d(i_{qc})$ of the current detection values or the current command values of the d axis and the q axis, and the frequency estimation value $\omega_{dc}$ (Equation (17)). In the present embodiment, the first power and the second power are active powers.

Accordingly, in the power conversion device of the vector control, the estimation value $\Delta\theta_{c\_H}$ of the phase deviation in the medium/high speed range can be computed on the basis of the active powers instead of the conventional extended induced voltage method.

As similar to the first embodiment, the processor computes the estimation value $\Delta\theta_{c\_L}$ of the phase deviation by performing proportional control and integral control such that the power deviation (deviation $\Delta Q_c$) between the reactive powers is zero in the low speed range where the frequency command value $\omega_r^*$ is less than a threshold value (FIG. 4 and FIG. 11). As depicted in FIG. 12, the processor computes the estimation value $\Delta\theta_{c\_H}$ of the phase deviation (phase deviation $\Delta\theta$) by performing proportional control and integral control such that the power deviation (deviation $\Delta P_c$) between the reactive powers is zero in the medium/high speed range where the frequency command value $\omega_r^*$ is equal to or larger than a threshold value.

Accordingly, stable and highly-accurate control of the magnet motor 1 can be realized in all the speed ranges.

Fourth Embodiment

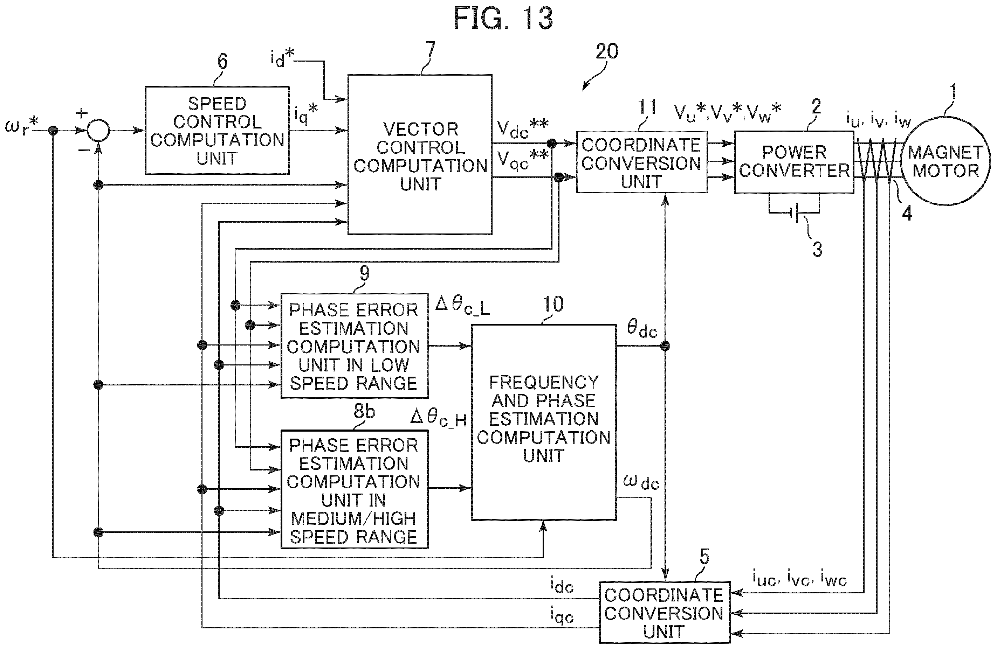

FIG. 13 is a configuration diagram of a power conversion device according to an embodiment.

In the third embodiment, the first active power $P_c$ is computed from the voltage command values $v_{dc}^{**}$ and $v_{qc}^{**}$ and the current detection values $i_{dc}$ and $i_{qc}$ of the $d_c$ axis and the $q_c$ axis, but in the fourth embodiment, the first active power $P_c$ is computed by using the amplitude value $V_1^*$ of the voltage command of the three-phase AC, the amplitude value $i_1$ of the current detection value, and a cosine signal of the phase $\theta_{vi}$.

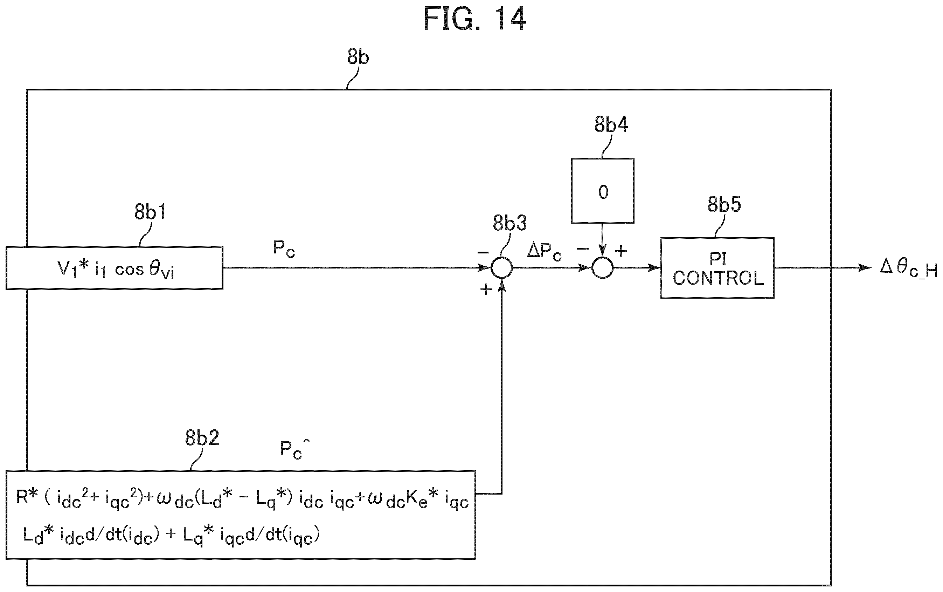

FIG. 14 is a phase error estimation computation unit 8b in the medium/high speed range of an embodiment of the present invention. The reference numeral 8b of the drawing corresponds to the reference numeral 8 in FIG. 2. The reference numerals 1 to 7 and 9 to 11 in the drawing are the same as those in FIG. 1.

The reference numerals 8b2, 8b3, 8b4, and 8b5 in FIG. 14 are the same as the reference numerals 8a2, 8a3, 8a4, and 8a5 in FIG. 12, respectively. In FIG. 14, in 8b1, the amplitude value $V_1^*$ of the voltage command of the three-phase AC is obtained in accordance with Equation (12) described above, the amplitude value $i_1$ of the current detection value is obtained in accordance with Equation (13) described above, the phase $\theta_{vi}$ is obtained in accordance with Equation (14) described above, and the active power $P_c$ is computed by using Equation (19).

[Equation 19]

$$P_c = v_1^* \, i_1 \cos[\theta_{vi}] \qquad \cdots (19)$$

Even if the present embodiment is used, highly-accurate control characteristics can be realized as similar to the first embodiment.

The main features of the fourth embodiment can also be summarized as follows.

As depicted in FIG. 14, the processor of the power conversion device 20 computes the first power (first active power $P_c$) from the product of the voltage amplitude value (amplitude value $V_1^*$ of the voltage command) of one phase of the three-phase AC, the current amplitude value (amplitude value $i_1$ of the current detection value) of the phase, and the cosine signal $\cos[\theta_{vi}]$ of the phase difference between the voltage command value and the current detection value of the phase (Equation (19)). The processor computes the second power (second active power $P_c^\wedge$) from the electrical circuit parameters ($R^*$, $L_d^*$, $L_q^*$, and $K_e^*$), the steady components (current detection values $i_{dc}$ and $i_{qc}$) and the transient components $dt/d(i_{dc})$ and $dt/d(i_{qc})$ of the current detection values or the current command values of the d axis and the q axis, and the frequency estimation value $\omega_{dc}$. Stable and highly-accurate control of the magnet motor 1 can be realized on the basis of the cosine signal of the three-phase AC.

Fifth Embodiment

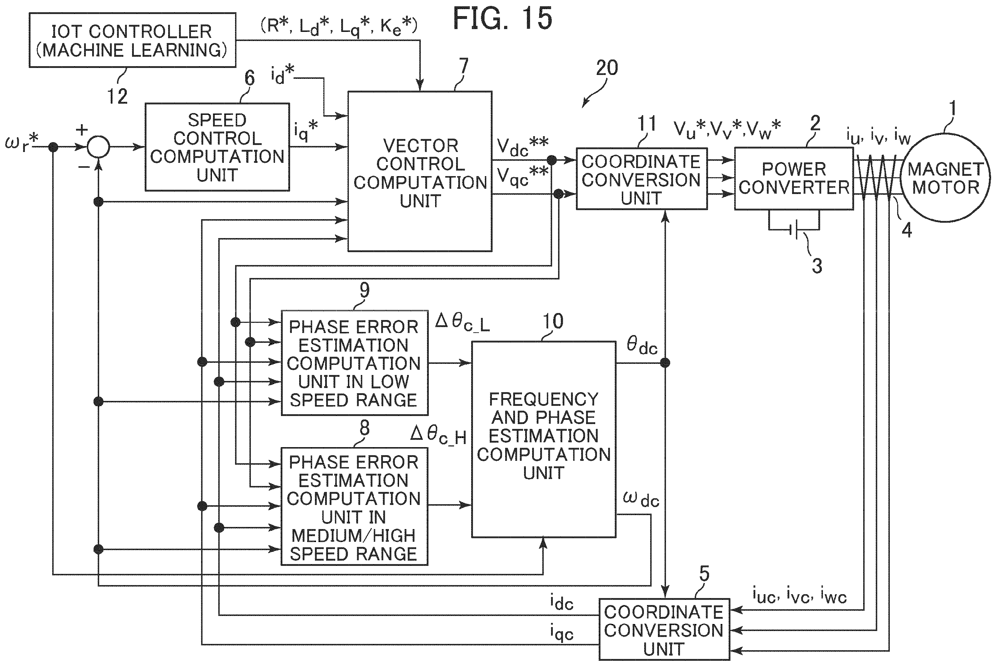

FIG. 15 is a configuration diagram of a power conversion device according to an embodiment.

The first to fourth embodiments are configured to set the electric circuit parameters of the magnet motor 1 in the controller (microcomputer or the like) of the power converter 2, but in the present embodiment, the state amount of control is fed back to a higher IOT controller, and then the machine-learned electric circuit parameters are re-set in the controller of the power converter.

The reference numeral 1 to 11 in the drawing are the same as those in FIG. 1. The reference numeral 12 denotes an IOT controller that executes machine learning.

In the present embodiment, the voltage command values $v_{dc}^{**}$ and $v_{qc}^{**}$, the current detection values $i_{dc}$ and $i_{qc}$, and the estimation value $\Delta\theta_c$ of the phase error are fed back to the higher IOT controller 12, and then the machine-learned electric circuit parameters ($R^*$, $L_d^*$, $L_q^*$, and $K_e^*$) are re-set in the controller of the power converter 2.

Even if the present embodiment is used, more stable and highly-accurate control characteristics can be realized as similar to the first embodiment.

The main features of the fifth embodiment can also be summarized as follows.

The processor of the power conversion device 20 transmits the voltage command values $v_{dc}^{**}$ and $v_{qc}^{**}$, the current detection values $i_{dc}$ and $i_{qc}$, and the estimation value $\Delta\theta_c$ of the phase deviation to the controller (IOT controller) of the higher device via a communication device.

The controller of the higher device analyzes (machine learning) the values received from the power conversion device 20 and transmits the analysis result to the power conversion device 20.

As depicted in FIG. 15, the processor of the power conversion device 20 receives the inductances $L_d^*$ and $L_q^*$ of the d axis and the q axis or the induced voltage coefficient $K_e^*$ of the magnet motor analyzed (machine learning) on the basis of the voltage command values $v_{dc}^{**}$ and $v_{qc}^{**}$, the current detection values $i_{dc}$ and $i_{qc}$, and the estimation value $\Delta\theta_c$ of the phase deviation from the controller (IOT controller) of the higher device via the communication device. The processor of the power conversion device 20 updates the electrical circuit parameters stored in a storage device of the power conversion device 20, with the received values. Accordingly, the electric circuit parameters can be automatically updated.

Sixth Embodiment

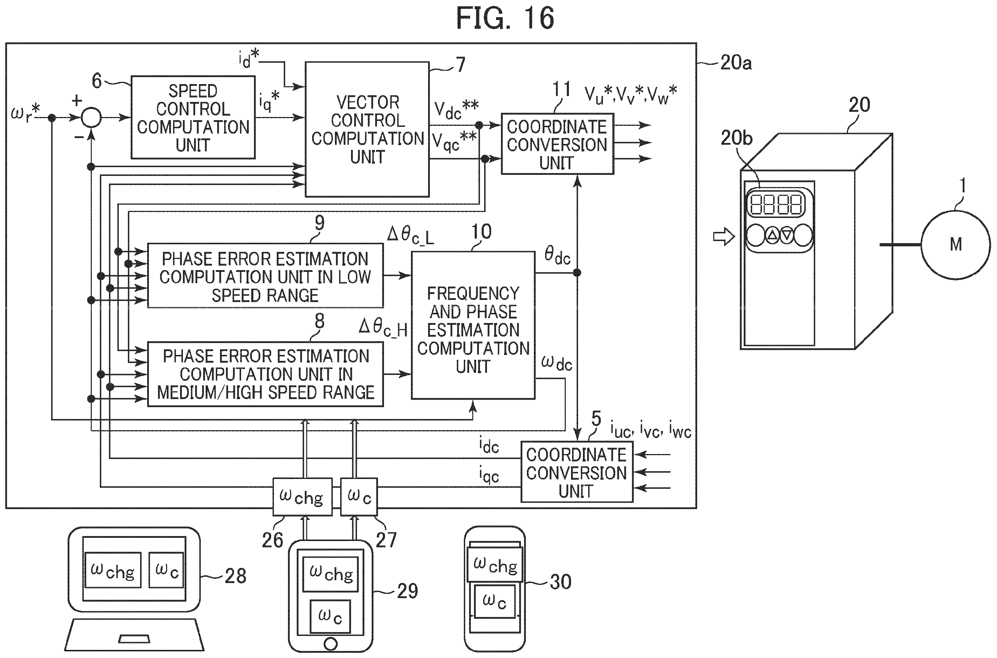

FIG. 16 is a configuration diagram of a power converter according to an embodiment. The present embodiment is an embodiment in which the first embodiment is applied to a magnet motor drive system. In the drawing, the constitutional elements of the reference numerals 1 and 5 to 11 are the same as those in FIG. 1.

The magnet motor 1 as a constitutional element of FIG. 1 is driven by the power conversion device 20. In the power conversion device 20, the constitutional elements of the reference numerals 5 to 11 in FIG. 1 are mounted as software 20a, and the constitutional elements of the reference numerals 2, 3, and 4 in FIG. 1 are mounted as hardware. In addition, "$\omega_{chg}$ that is the switching frequency 26 between the low speed range and the medium/high speed range," and "$\omega_c$ that is the control response 27 of the phase error in the low speed range" of the software 20a can be set and changed by a higher device such as a digital operator 20b, a personal computer 28, a tablet 29, or a smartphone 30.

If the present embodiment is applied to the magnet motor drive system, highly-accurate control characteristics can be realized in the position sensorless vector control. In addition, "$\omega_{chg}$ that is the switching frequency 26 between the low speed range and the medium/high speed range," and "$\omega_c$ that is the control response 27 of the phase error in the low speed range" may be set on a field bus of a programmable logic controller, a local area network connected to a computer, an IOT controller, or the like.

Further, although the present embodiment is disclosed by using the first embodiment, the second to fifth embodiments may be used.

The main features of the sixth embodiment can also be summarized as follows.

The power conversion device 20 depicted in FIG. 16 includes a storage device (for example, a non-volatile memory) for storing the threshold value (switching frequency 26, $\omega_{chg}$) and the control response 27 ($\omega_c$ or the like) used for proportional control or integral control. The power conversion device 20 includes a communication device for communicating with an input device (digital operator 20b or the like) for setting the threshold value (switching frequency 26, $\omega_{chg}$) and the control response 27 ($\omega_c$ or the like), or the external devices (the personal computer 28, the tablet 29, the smartphone 30, and the like) that set the threshold value and the control response.

Accordingly, the user can easily set the threshold value (switching frequency 26, $\omega_{chg}$) and the control response 27 ($\omega_c$ or the like).

In the first to fifth embodiments, the current detection values $i_{dc}$ and $i_{qc}$ are used in Equation (6) as the first reactive power $Q_c$ and Equation (7) as the second reactive power $Q_c^\wedge$, but the current command values $i_d^*$ and $i_q^*$ may be used. In addition, the current detection values $i_{dc}$ and $i_{qc}$ are used in Equation (16) as the first active power $P_c$ and Equation (17) as the second reactive power $P_c^\wedge$, but the current command values $i_d^*$ and $i_q^*$ may be used.

Further, in the first to fifth embodiments, the voltage correction values $\Delta v_{dc}$ and $\Delta v_{qc}$ are created from the current command values $i_d^*$ and $i_q^*$ and the current detection values $i_{dc}$ and $i_{qc}$, and the computation depicted in Equation (4) for adding the voltage correction values and the voltage reference value of the vector control is performed, but the intermediate current command values $i_d^{**}$ and $i_q^{**}$ depicted in Equation (20) used for the vector control computation are created from the current command values $i_q^*$ and $i_q^*$ and the current detection values $i_{dc}$ and $i_{qc}$, and the vector control computation depicted in Equation (21) may be performed by using the frequency estimation value $\omega_{dc}$ and the electric circuit parameters of the magnet motor 1.

[Equation 20]

$$\begin{bmatrix} i_d^{**} = (K_{pd1} + \dfrac{K_{id1}}{s})(i_d^* - i_{dc}) \\[3mm] i_q^{**} = (K_{pq1} + \dfrac{K_{iq1}}{s})(i_q^* - i_{qc}) \end{bmatrix} \quad \cdots (20)$$

[Equation 21]

$$\begin{bmatrix} v_{dc}^{***} = R^* i_d^{**} - \omega_r^{\wedge} L_q^* \dfrac{1}{1+T_q s} i_q^{**} \\[3mm] v_{qc}^{***} = R^* i_q^{**} + \omega_r^{\wedge} L_d^* \dfrac{1}{1+T_d s} i_d^{**} + \omega_r^{\wedge} K_e^{**} \end{bmatrix} \quad \cdots (21)$$

Here, $K_{pd1}$ is a proportional gain of current control of the $d_c$ axis, $K_{id1}$ is an integral gain of current control of the $d_c$ axis, $K_{pq1}$ is a proportional gain of current control of the $q_c$ axis, $K_{iq1}$ is an integral gain of current control of the $q_c$ axis, $T_d$ is an electric time constant ($L_d/R$) of the d axis, and $T_q$ is an electric time constant ($L_q/R$) of the q axis.

Alternatively, from the current command values $i_d^*$ and $i_q^*$ and the current detection values $i_{dc}$ and $i_{qc}$, a voltage correction value $\Delta v_{d\_p}^*$ of the proportional computation component of the $d_c$ axis used for the vector control computation, a voltage correction value $\Delta v_{d\_i}^*$ of the integral computation component of the $d_c$ axis, a voltage correction value $\Delta v_{q\_p}^*$ of the proportional computation component of the $q_c$ axis, and a voltage correction value $\Delta v_{q\_i}^*$ of the integral computation component of the $q_c$ axis are created by Equation (22), and the vector control computation depicted in Equation (23) using the frequency value estimation $\omega_{dc}$ and the electric circuit parameters of the magnet motor 1 may be performed.

[Equation 22]

$$\begin{bmatrix} \Delta v_{d\_p}^* = K_{pd2}(i_d^* - i_{dc}) \\[3mm] \Delta v_{d\_i}^* = \dfrac{K_{id2}}{s}(i_d^* - i_{dc}) \\[3mm] \Delta v_{q\_p}^* = K_{pq2}(i_q^* - i_{qc}) \\[3mm] \Delta v_{q\_i}^* = \dfrac{K_{iq2}}{s}(i_q^* - i_{qc}) \end{bmatrix} \quad \cdots (22)$$

[Equation 23]

$$\begin{bmatrix} v_{dc}^{****} = (\Delta v_{d\_p}^* + \Delta v_{d\_i}^*) - \omega_r^{\wedge} \dfrac{L_q^*}{R^*} \Delta v_{q\_i}^* \\[3mm] v_{qc}^{****} = (\Delta v_{q\_p}^* + \Delta v_{q\_i}^*) + \omega_r^{\wedge} \dfrac{L_d^*}{R^*} \Delta v_{d\_i}^* + \omega_r^{\wedge} K_e^* \end{bmatrix} \quad \cdots (23)$$

Here, the vector control computation depicted in Equation (24) may be performed by using $K_{pd2}$ as a proportional gain of the current control of the $d_c$ axis, $K_{id2}$ as an integral gain of the current control of the $d_c$ axis, $K_{pq2}$ as a proportional gain of the current control of the $q_c$ axis, $K_{iq2}$ as an integral gain of the current control of the $q_c$ axis, a primary delay signal $i_{qced}$ of the current command value $i_d^*$ of the $d_c$ axis and the current detection value $i_{qc}$ of the $q_c$ axis, the frequency estimation value $\omega_{dc}$, and the electric circuit parameters of the magnet motor 1.

[Equation 24]

$$\left[\begin{array}{l} v_{dc}^{\ *****} = R^* i_d^{\ *} - \omega_r^{\ \wedge} L_q^{\ *} i_{qctd} \\ v_{qc}^{\ *****} = R^* i_{qctd} + \omega_r^{\ \wedge} L_d^{\ *} i_d^{\ *} + \omega_r^{\ \wedge} Ke^{**} \end{array}\right] \quad \cdots (24)$$

It should be noted that in the first to sixth embodiments, the switching element configuring the power converter 2 may be a silicon (Si) semiconductor element or a wide bandgap semiconductor element such as silicon carbide (SiC) or gallium nitride (GaN).

The above embodiments are examples for explaining the present invention and have been omitted and simplified as appropriate in order to clarify the explanation. The present invention can be carried out in various other forms. Unless otherwise specified, each constitutional element may be singular or multiple. The position, size, shape, range, and the like of each constitutional element depicted in the drawings do not represent the actual position, size, shape, range, and the like in some cases in order to facilitate understanding of the invention. Therefore, the present invention is not necessarily limited to the positions, sizes, shapes, ranges, and the like disclosed in the drawings. Examples of the various types of information are described by expressions such as "table," "list," and "queue," but the various types of information may be expressed by data structures other than these. For example, various types of information such as "XX table," "XX list," and "XX queue" may be "XX information." When explaining identification information, expressions such as "identification information," "identifier," "name," "ID," and "number" are used, but they can be replaced with each other. In the case where there are multiple constitutional elements having the same or similar functions, they are described by adding different subscripts to the same reference numerals in some cases. In addition, in the case where it is not necessary to distinguish these constitutional elements from each other, they are described by omitting the subscripts in some cases. In the embodiments, a process performed by executing a program is described in some cases. Here, a computer executes a program by a processor (for example, a CPU or a GPU), and performs a process specified by the program while using a storage resource (for example, a memory), an interface device (for example, a communication port), or the like. Therefore, the main body of the process performed by executing the program may be the processor. Similarly, the main body of the process performed by executing the program may be a controller, a device, a system, a computer, or a node having a processor. The main body of the process performed by executing the program may be a computation unit, and may include a dedicated circuit for performing a specific process. Here, the dedicated circuit is a field programmable gate array (FPGA), an application specific integrated circuit (ASIC), a complex programmable logic device (CPLD), or the like. The program may be installed on a computer from a program source. The program source may be, for example, a program distribution server or a computer readable storage medium. In the case where the program source is a program distribution server, the program distribution server includes a processor and a storage resource for storing a program to be distributed, and the processor of the program distribution server may distribute the program to be distributed to other computers. In addition, in the embodiments, two or more programs may be realized as one program, or one program may be realized as two or more programs.

It should be noted that the embodiments of the present invention may have the following modes.

(C1). In a power conversion device for controlling the output frequency, the output voltage, and the output current of a magnet motor, the deviation between the phase of control and the phase of the magnetic flux of the motor is estimated such that a first power computed from the output voltage and the output current of the magnet motor follows a second power computed from electric circuit parameters of the magnet motor, steady components and transient components of the output current, and a frequency estimation value, and the frequency estimation value is controlled by using the estimation value of the relevant phase deviation.

(C2). In a power conversion device for controlling the output frequency, the output voltage, and the output current of a magnet motor, the deviation between the phase of control and the phase of the magnetic flux of the motor is estimated such that a first reactive power computed from the output voltage and the output current of the magnet motor follows a second reactive power computed from electric circuit parameters of the magnet motor, steady components and transient components of the output current, and a frequency estimation value, and the frequency estimation value is controlled by using the estimation value of the relevant phase deviation.

(C3). In a power conversion device for controlling the output frequency, the output voltage, and the output current of a magnet motor, the deviation between the phase of control and the phase of the magnetic flux of the motor is estimated such that a first active power computed from the output voltage and the output current of the magnet motor follows a second active power computed from electric circuit parameters of the magnet motor, steady components and transient components of the output current, and a frequency estimation value, and the frequency estimation value is controlled by using the estimation value of the relevant phase deviation.

(C4). In a power conversion device of vector control that computes voltage command values of the d axis and the q axis by using current command values and current detection values of the d axis as the magnetic flux axis of a magnet motor and the q axis as the torque axis, and a frequency estimation value, the deviation between the phase of control and the phase of the magnetic flux of the motor is estimated such that a first reactive power obtained by multiplying the voltage command values and the current detection values of different components of the d axis and the q axis and adding them (expressed as adding in consideration of the positive and negative of the values) follows a second reactive power computed from electric circuit parameters of the magnet motor, steady components and transient components of the current detection values or the current command values of the d axis and the q axis, and a frequency estimation value, and the frequency estimation value is controlled by using the estimation value of the relevant phase deviation.

(C5). In a power conversion device of vector control that computes voltage command values of three-phase AC by using current command values and current detection values of the three-phase AC of a magnet motor and a frequency estimation value, the deviation between the phase of control and the phase of the magnetic flux of the motor is estimated such that a first reactive power obtained by multiplying a voltage amplitude value and a current amplitude value of one phase of the three-phase AC and a sine signal of the phase difference between the voltage command value and the current detection value follows a second reactive power computed from electric circuit parameters of the magnet motor, steady components and transient components of the current detection values or the current command values of the d axis and the q axis, and the frequency estimation value, and the frequency estimation value is controlled by using the estimation value of the relevant phase deviation.

(C6). In a power conversion device of vector control that computes voltage command values of the d axis and the q axis by using current command values and current detection values of the d axis as the magnetic flux axis of a magnet motor and the q axis as the torque axis, and a frequency estimation value, the deviation between the phase of control and the phase of the magnetic flux of the motor is estimated such that a first active power obtained by multiplying the voltage command values and the current detection values of the same component of the d axis and the q axis and adding them follows a second active power computed from electric circuit parameters of the magnet motor, steady components and transient components of the current detection values or the current command values of the d axis and the q axis, and the frequency estimation value, and the frequency estimation value is controlled by using the estimation value of the relevant phase deviation.

(C7). In a power conversion device of vector control that computes voltage command values of three-phase AC by using current command values and current detection values of the three-phase AC of a magnet motor and a frequency estimation value, a phase error (phase deviation) that is the deviation between the phase of control and the phase of the magnetic flux of the motor is estimated such that a first active power obtained by multiplying a voltage amplitude value and a current amplitude value of one phase of the three-phase AC and a cosine signal of the phase difference between the voltage command value and the current detection value follows a second active power computed from electric circuit parameters of the magnet motor, steady components and transient components of the current detection values or the current command values of the d axis and the q axis, and the frequency estimation value, and the frequency estimation value is controlled such that the estimation value of the relevant phase error follows the command value thereof.

(C8). In the power conversion device according to any one of (C1) to (C7), the estimation computation of the phase error that is the deviation between the phase of control and the phase of the magnetic flux of the motor is performed by proportional control and integral control performed such that the deviation between the first and second reactive powers or the deviation between the first and second reactive powers is zero.

(C9). In the power conversion device according to (C8), on the basis of the relationship between the electric circuit parameters of the magnet motor and the frequency estimation value, the estimation computation of the phase error is performed by proportional control and integral control performed such that the deviation between the first and second reactive power information is zero if the magnet motor is in the low speed range and the deviation between the first and second active power information is zero if the magnet motor is in the medium/high speed range.

(C10). In the power conversion device according to (C8), on the basis of the relationship between the electric circuit parameters of the magnet motor and the frequency estimation value, proportional control and integral control performed so as to make the deviation between the first and second reactive power information is zero if the magnet motor is in the low speed range, and the phase error is computed directly by an extended induced voltage method if the magnet motor is in the medium/high speed range.

(C11). In the power conversion device according to (C9) and (C10), a frequency value for switching control between the low speed range and the medium/high speed range, and a control response set in proportional control or integral control for estimating the phase error are set in a microcomputer internal memory or the like mounted in the power conversion device including a power converter, and can be freely set and changed by connecting thereto a digital operator, a personal computer, a tablet, or a smartphone device.

(C12). In the power conversion device according to (C11), the voltage command values, the current detection values, and the estimation value of the phase error are fed back to an IOT controller as a higher device for analysis, and the d-axis and q-axis inductances and the induced voltage coefficient of the magnet motor are automatically corrected.

According to (C1) to (C12), the phase error is estimated by using the reactive power computed using the steady components and the transient components of the current detection values, and the output frequency of the magnet motor is estimated by using the relevant phase error, so that a torque shock when switching from the low speed range to the medium/high speed range can be prevented, and it is possible to provide a power converter that realizes highly-accurate control characteristics without adjusting the electric circuit parameters and the control gains of the magnet motor set in a controller.

Description of Reference Characters

1: Magnet motor
2: Power converter
3: DC power supply
4: Current detector
5: Coordinate conversion unit
6: Speed control computation unit
7: Vector control computation unit
8, 8a, 8b: Phase error estimation computation unit in medium/high speed range
9, 9a, 9b: Phase error estimation computation unit in low speed range
10: Frequency and phase estimation computation unit
11: Coordinate conversion unit
12: IOT controller
20: Power conversion device
20a: Software (software part) of power conversion device
20b: Digital operator of power conversion device
21: Voltage detector
22: Current detector
23: Encoder
24: Calculation unit for voltage/current of vector component
25: Observation unit for waveforms at various points
26: Set value of switching frequency between low speed range and medium/high speed range
27: Set value of control response in low speed range
28: Personal computer
29: Tablet
30: Smartphone
$i_d^*$: Current command value of d axis
$i_q^*$ : Current command value of q axis
$i_{dc}$: Current detection value (steady component) of d axis
$i_{dc}$: Current detection value (steady component) of q axis
$d/dt(i_{dc})$: Transient component of current detection value of d axis
$d/dt(i_{qc})$: Transient component of current detection value of q axis
$\omega_{dc}$: Frequency estimation value
wr: Speed of magnet motor 1
$v_{dc}^*, v_{dc}^{**}, v_{dc}^{**}, v_{dc}^{***}, v_{dc}^{****}, v_{dc}^{*****}$: Voltage command value of d axis
$v_{qc}^*, v_{qc}^{**}, v_{qc}^{***}, v_{qc}^{****}, v_{qc}^{****}$ : Voltage command value of q axis
$Q_c$: First reactive power
$Q_c^\wedge$: Second reactive power
$P_C$: First active power
$P_C^\wedge$: Second active power
$\Delta\theta_{c\_L}$: Estimation value of phase error in low speed range $\Delta\theta_{c\_H}$: Estimation value of phase error in medium/high speed range
$\Delta\theta_c$: Estimation value of phase error

**Claims**

1. A power conversion device (20) comprising:
   a processor that:

   computes a first power ($Q_c$) from a voltage and a current of a magnet motor (1),
   computes a second power ($Q_c^\wedge$) from electric circuit parameters of the magnet motor (1), and current detection values (idc, iqc),
estimates a phase deviation indicating a deviation between a phase of control and a phase of a magnetic flux of the magnet motor (1) such that the first power ($Q_c$) follows the second power ($Q_c$^), and computes a frequency estimation value ($\omega$dc) from an estimation value of the phase deviation,
**characterized in that**
the second power ($Q_c$^) is further computed from time derivatives of the current detection values (d/dt(idc), d/dt(iqc)) of the magnet motor (1), and the frequency estimation value ($\omega$dc) of the magnet motor (1).

2. The power conversion device (20) according to claim 1,
wherein
the first power ($Q_c$) and the second power ($Q_c$^) are reactive powers.

3. The power conversion device (20) according to claim 1,
wherein
the first power ($Q_c$) and the second power ($Q_c$^) are active powers (PC, PC^).

4. The power conversion device (20) according to claim 2,
wherein

the processor
computes the first power ($Q_c$) from a difference between products of voltage command values and current detection values of different components of a d axis as a magnetic flux axis of the magnet motor (1) and a q axis as a torque axis of the magnet motor (1), and
computes the second power ($Q_c$^) from the electric circuit parameters, steady components and transient components of current detection values or current command values of the d axis and the q axis (id*, iq*), and the frequency estimation value ($\omega$dc).

5. The power conversion device (20) according to claim 2,
wherein

the processor
computes the first power ($Q_c$) from a product of a voltage amplitude value of one phase of three-phase AC, a current amplitude value of the phase, and a sine signal of a phase difference between a voltage command value and a current detection value of the phase, and
computes the second power ($Q_c$^) from the electric circuit parameters, steady components and transient components of current detection values or current command values of a d axis and a q axis (id*, iq*), and the frequency estimation value (wdc).

6. The power conversion device (20) according to claim 3,
wherein

the processor
computes the first power ($Q_c$) from a sum of products of voltage command values and current detection values of a same component of a d axis as a magnetic flux axis of the magnet motor (1) and a q axis as a torque axis of the magnet motor (1), and
computes the second power ($Q_c$^) from the electric circuit parameters, steady components and transient components of current detection values or current command values of the d axis and the q axis (id*, iq*), and the frequency estimation value ($\omega$dc).

7. The power conversion device (20) according to claim 3,
wherein

the processor
computes the first power ($Q_c$) from a product of a voltage amplitude value of one phase of three-phase AC, a current amplitude value of the phase, and a cosine signal of a phase difference between a voltage command value and a current detection value of the phase, and
computes the second power ($Q_c$^) from the electric circuit parameters, steady components and transient components of current detection values or current command values of a d axis and a q axis (id*, iq*), and the frequency estimation value (wdc).

8. The power conversion device (20) according to claim 1, wherein

the processor
computes the estimation value of the phase deviation by performing proportional control and integral control such that a power deviation indicating a deviation between the first power ($Q_c$) and the second power ($Q_c$^) is zero.

9. The power conversion device (20) according to claim 8, wherein

the processor
computes the estimation value of the phase deviation by performing the proportional control and the integral control such that the power deviation between reactive powers is zero in a low speed range where a frequency command value is less than a threshold value, and
computes the estimation value of the phase deviation by performing the proportional control and the integral control such that the power deviation between active powers (PC, PC^) is zero in a medium/high speed range where the frequency command value is equal to or larger than the threshold value.

10. The power conversion device (20) according to claim 8, wherein

the processor
computes the estimation value of the phase deviation by performing the proportional control and the integral control such that the power deviation between reactive powers is zero in a low speed range where a frequency command value is less than a threshold value, and
computes the estimation value of the phase deviation by an extended induced voltage method in a medium/high speed range where the frequency command value is equal to or larger than the threshold value.

11. The power conversion device (20) according to claim 9, the device comprising:

a storage device that stores the threshold value and a control response used for the proportional control or the integral control;
an input device (20b) that sets the threshold value and the control response; or
a communication device that communicates with an external device for setting the threshold value and the control response.

12. The power conversion device (20) according to claim 11, wherein

the processor
transmits voltage command values, current detection values, and an estimation value of the phase deviation to a controller of a higher device via the communication device,
receives inductances of a d axis and a q axis of the magnet motor (1) or an induced voltage coefficient, the inductances and the induced voltage coefficient being analyzed on a basis of the voltage command values, the current detection values, and the estimation value of the phase deviation, from the controller of the higher device via the communication device, and
updates the electric circuit parameters with the received values.

13. The power conversion device (20) according to claim 1, wherein

the processor
computes the second power ($Q_c$^) from the electrical circuit parameters, steady components and transient components of current detection values or current command values of a d axis and a q axis (id*, iq*), and the frequency estimation value (wdc).

**Patentansprüche**

1. Leistungsumsetzungsvorrichtung (20), die Folgendes umfasst:

   einen Prozessor, der
   eine erste Leistung ($Q_c$) aus einer Spannung und einem Strom eines Magnetmotors (1) berechnet,
   eine zweite Leistung ($Q_c^{\wedge}$) aus elektrischen Schaltungsparametern des Magnetmotors (1) und Stromdetektionswerten (idc, iqc) berechnet,
   eine Phasenabweichung schätzt, die eine Abweichung zwischen einer Phase der Steuerung und einer Phase
   eines Magnetflusses des Magnetmotors (1) angibt, derart, dass die erste Leistung ($Q_c$) der zweiten Leistung
   ($Q_c^{\wedge}$) folgt, und einen Frequenzschätzwert ($\omega$dc) aus einem Schätzwert der Phasenabweichung berechnet,
   **dadurch gekennzeichnet, dass**
   die zweite Leistung ($Q_c^{\wedge}$) ferner aus Zeitableitungen (d/dt(idc), d/dt(iqc)) der Stromdetektionswerte des Magnetmotors (1) und dem Frequenzschätzwert ($\omega$dc) des Magnetmotors (1) berechnet wird.

2. Leistungsumsetzungsvorrichtung (20) nach Anspruch 1, wobei
   die erste Leistung ($Q_c$) und die zweite Leistung ($Q_c^{\wedge}$) Blindleistungen sind.

3. Leistungsumsetzungsvorrichtung (20) nach Anspruch 1, wobei
   die erste Leistung ($Q_c$) und die zweite Leistung ($Q_c^{\wedge}$) Wirkleistungen (PC, PC^) sind

4. Leistungsumsetzungsvorrichtung (20) nach Anspruch 2, wobei

   der Prozessor
   die erste Leistung ($Q_c$) aus einer Differenz zwischen Produkten von Spannungsbefehlswerten und Stromdetektionswerten verschiedener Komponenten einer d-Achse als einer Magnetflussachse des Magnetmotors (1)
   und einer q-Achse als einer Drehmomentachse des Magnetmotors (1) berechnet, und
   die zweite Leistung ($Q_c^{\wedge}$) aus den elektrischen Schaltungsparametern, konstanten Komponenten und transienten Komponenten von Stromdetektionswerten oder Strombefehlswerten (id*, iq*) der d-Achse und der q-Achse
   und dem Frequenzschätzwert ($\omega$dc) berechnet.

5. Leistungsumsetzungsvorrichtung (20) nach Anspruch 2, wobei

   der Prozessor
   die erste Leistung ($Q_c$) aus einem Produkt eines Spannungsamplitudenwertes einer Phase eines Dreiphasen-
   Wechselstroms, eines Stromamplitudenwertes der Phase und eines Sinus-Signals einer Phasendifferenz
   zwischen einem Spannungsbefehlswert und einem Stromdetektionswert der Phase berechnet, und
   die zweite Leistung ($Q_c^{\wedge}$) aus den elektrischen Schaltungsparametern, konstanten Komponenten und transienten Komponenten von Stromdetektionswerten oder Strombefehlswerten (id*, iq*) einer d-Achse und einer q-
   Achse und dem Frequenzschätzwert ($\omega$dc) berechnet.

6. Leistungsumsetzungsvorrichtung (20) nach Anspruch 3, wobei

   der Prozessor
   die erste Leistung ($Q_c$) aus einer Summe von Produkten von Spannungsbefehlswerten und Stromdetektionswerten derselben Komponente einer d-Achse als einer Magnetflussachse des Magnetmotors (1) und einer q-
   Achse als einer Drehmomentachse des Magnetmotors (1) berechnet, und
   die zweite Leistung ($Q_c^{\wedge}$) aus den elektrischen Schaltungsparametern, konstanten Komponenten und transienten Komponenten von Stromdetektionswerten oder Strombefehlswerten (id*, iq*) der d-Achse und der q-Achse
   und dem Frequenzschätzwert ($\omega$dc) berechnet.

7. Leistungsumsetzungsvorrichtung (20) nach Anspruch 3, wobei

   der Prozessor
   die erste Leistung ($Q_c$) aus einem Produkt eines Spannungsamplitudenwertes einer Phase eines Dreiphasen-
   Wechselstroms, eines Stromamplitudenwertes der Phase und eines Cosinus-Signals einer Phasendifferenz
   zwischen einem Spannungsbefehlswert und einem Stromdetektionswert der Phase berechnet, und
   die zweite Leistung ($Q_c^{\wedge}$) aus den elektrischen Schaltungsparametern, konstanten Komponenten und transienten Komponenten von Stromdetektionswerten oder Strombefehlswerten (id*, iq*) einer d-Achse und einer q-Achse und dem Frequenzschätzwert ($\omega$dc) berechnet.

8. Leistungsumsetzungsvorrichtung (20) nach Anspruch 1, wobei

der Prozessor
den Schätzwert der Phasenabweichung durch Durchführen einer Proportionalsteuerung und einer Integralsteuerung, derart, dass eine Leistungsabweichung, die eine Abweichung zwischen der ersten Leistung ($Q_c$) und der zweiten Leistung ($Q_c$^) angibt, null ist, berechnet.

9. Leistungsumsetzungsvorrichtung (20) nach Anspruch 8, wobei

der Prozessor
den Schätzwert der Phasenabweichung durch Durchführen der Proportionalsteuerung und der Integralsteuerung, derart, dass die Leistungsabweichung zwischen den Blindleistungen null ist, in einem niedrigen Drehzahlbereich, in dem der Frequenzbefehlswert kleiner als ein Schwellenwert ist, berechnet, und
den Schätzwert der Phasenabweichung durch Durchführen der Proportionalsteuerung und der Integralsteuerung, derart, dass die Leistungsabweichung zwischen den Wirkleistungen (PC, PC^) null ist, in einem mittleren/hohen Drehzahlbereich, in dem der Frequenzbefehlswert größer oder gleich dem Schwellenwert ist, berechnet.

10. Leistungsumsetzungsvorrichtung (20) nach Anspruch 8, wobei

der Prozessor
den Schätzwert der Phasenabweichung durch Durchführen der Proportionalsteuerung und der Integralsteuerung, derart, dass die Leistungsabweichung zwischen den Blindleistungen null ist, in einem niedrigen Drehzahlbereich, in dem ein Frequenzbefehlswert kleiner als ein Schwellenwert ist, berechnet, und
den Schätzwert der Phasenabweichung durch ein Verfahren einer erweiterten induzierten Spannung in einem mittleren/hohen Drehzahlbereich, in dem der Frequenzbefehlswert größer oder gleich dem Schwellenwert ist, berechnet.

11. Leistungsumsetzungsvorrichtung (20) nach Anspruch 9,
wobei die Vorrichtung Folgendes umfasst:

eine Speichervorrichtung, die den Schwellenwert und eine Steuerungsantwort, die für die Proportionalsteuerung oder die Integralsteuerung verwendet wird, speichert;
eine Eingangsvorrichtung (20b), die den Schwellenwert und die Steuerungsantwort einstellt; oder
eine Kommunikationsvorrichtung, die zum Einstellen des Schwellenwerts und der Steuerungsantwort mit einer externen Vorrichtung kommuniziert.

12. Leistungsumsetzungsvorrichtung (20) nach Anspruch 11, wobei

der Prozessor
Spannungsbefehlswerte, Stromdetektionswerte und einen Schätzwert der Phasenabweichung über die Kommunikationsvorrichtung an einer Steuereinheit einer höheren Vorrichtung sendet,
Induktivitäten einer d-Achse und einer q-Achse des Magnetmotors (1) oder einen Koeffizienten einer induzierten Spannung, wobei die Induktivitäten und der Koeffizient einer induzierten Spannung auf der Grundlage der Spannungsbefehlswerte, der Stromdetektionswerte und des Schätzwertes der Phasenabweichung analysiert werden, über die Kommunikationsvorrichtung von der Steuereinheit der höheren Vorrichtung empfängt, und
die elektrischen Schaltungsparameter mit den empfangenen Werten aktualisiert.

13. Leistungsumsetzungsvorrichtung (20) nach Anspruch 1, wobei

der Prozessor
die zweite Leistung ($Q_c$^) aus den elektrischen Schaltungsparametern, konstanten Komponenten und transienten Komponenten von Stromdetektionswerten oder Strombefehlswerten (id*, iq*) einer d-Achse und einer q-Achse und dem Frequenzschätzwert ($\omega$dc) berechnet.

**Revendications**

1. Dispositif de conversion de puissance (20) comprenant :
un processeur qui :

   calcule une première puissance (Q$_c$) à partir d'une tension et d'un courant d'un moteur magnétique (1),
   calcule une deuxième puissance (Q$_c$$^\wedge$) à partir de paramètres de circuit électrique du moteur magnétique (1), et des valeurs de détection de courant (idc, iqc),
   estime une déviation de phase indiquant une déviation entre une phase de commande et une phase de flux magnétique du moteur magnétique (1) de telle sorte que la première puissance (Q$_c$) suit la deuxième puissance (Q$_c$$^\wedge$), et calcule une valeur d'estimation de fréquence (ωdc) à partir d'une valeur d'estimation de la déviation de phase,
   **caractérisé en ce que**
   la deuxième puissance (Q$_c$$^\wedge$) est en outre calculée à partir de dérivées temporelles des valeurs de détection de courant (d/dt(idc), d/dt/iqc) du moteur magnétique (1), et de la valeur d'estimation de fréquence (ωdc) du moteur magnétique (1).

2. Dispositif de conversion de puissance (20) selon la revendication 1, dans lequel
la première puissance (Q$_c$) et la deuxième puissance (Q$_c$$^\wedge$) sont des puissances réactives.

3. Dispositif de conversion de puissance (20) selon la revendication 1, dans lequel
la première puissance (Q$_c$) et la deuxième puissance (Q$_c$$^\wedge$) sont des puissances actives (PC, PC^).

4. Dispositif de conversion de puissance (20) selon la revendication 2, dans lequel

   le processeur
   calcule la première puissance (Q$_c$) à partir d'une différence entre des produits de valeurs d'ordre de tension et de valeurs de détection de courant de différentes composantes d'un axe d à titre d'axe de flux magnétique du moteur magnétique (1) et d'un axe q à titre d'axe de couple du moteur magnétique (1), et
   calcule la deuxième puissance (Q$_c$$^\wedge$) à partir des paramètres de circuit électrique, de composantes continues et de composantes transitoires de valeurs de détection de courant ou de valeurs d'ordre de courant de l'axe d et de l'axe q (id*, iq*), et de la valeur d'estimation de fréquence (ωdc).

5. Dispositif de conversion de puissance (20) selon la revendication 2, dans lequel

   le processeur
   calcule la première puissance (Q$_c$) à partir d'un produit d'une valeur d'amplitude de tension d'une phase d'un courant alternatif triphasé, d'une valeur d'amplitude de courant de la phase, et d'un signal sinusoïdal d'une différence de phase entre une valeur d'ordre de tension et une valeur de détection de courant de la phase, et
   calcule la deuxième puissance (Q$_c$$^\wedge$) à partir des paramètres de circuit électrique, de composantes continues et de composantes transitoires de valeurs de détection de courant ou de valeurs d'ordre de courant d'un axe d et d'un axe q (id*, iq*), et de la valeur d'estimation de fréquence (ωdc).

6. Dispositif de conversion de puissance (20) selon la revendication 3, dans lequel

   le processeur
   calcule la première puissance (Q$_c$) à partir d'une somme de produits de valeurs d'ordre de tension et de valeurs de détection de courant d'une même composante d'un axe d à titre d'axe de flux magnétique du moteur magnétique (1) et d'un axe q à titre d'axe de couple du moteur magnétique (1), et
   calcule la deuxième puissance (Q$_c$$^\wedge$) à partir des paramètres de circuit électrique, de composantes continues et de composantes transitoires de valeurs de détection de courant ou de valeurs d'ordre de courant de l'axe d et de l'axe q (id*, iq*), et de la valeur d'estimation de fréquence (ωdc).

7. Dispositif de conversion de puissance (20) selon la revendication 3, dans lequel

   le processeur
   calcule la première puissance (Q$_c$) à partir d'un produit d'une valeur d'amplitude de tension d'une phase d'un courant alternatif triphasé, d'une valeur d'amplitude de courant de la phase, et d'un signal sinusoïdal d'une différence de phase entre une valeur d'ordre de tension et une valeur de détection de courant de la phase, et calcule la deuxième puissance ($Q_c^{\wedge}$) à partir des paramètres de circuit électrique, de composantes continues et de composantes transitoires de valeurs de détection de courant ou de valeurs d'ordre de courant d'un axe d et d'un axe q (id*, iq*), et de la valeur d'estimation de fréquence ($\omega$dc).

8. Dispositif de conversion de puissance (20) selon la revendication 1, dans lequel

le processeur
calcule la valeur d'estimation de la déviation de phase en effectuant une commande proportionnelle et une commande intégrale de telle sorte qu'une déviation de puissance indiquant une déviation entre la première puissance ($Q_c$) et la deuxième puissance ($Q_c^{\wedge}$) est égale à zéro.

9. Dispositif de conversion de puissance (20) selon la revendication 8, dans lequel

le processeur
calcule la valeur d'estimation de la déviation de phase en effectuant la commande proportionnelle et la commande intégrale de telle sorte que la déviation de puissance entre puissances réactives est égale à zéro dans une plage de vitesses basses où une valeur d'ordre de fréquence est inférieure à une valeur seuil, et calcule la valeur d'estimation de la déviation de phase en effectuant la commande proportionnelle et la commande intégrale de telle sorte que la déviation de puissance entre puissances actives (PC, PC^) est égale à zéro dans une plage de vitesses moyennes/élevées où la valeur d'ordre de fréquence est égale ou supérieure à la valeur seuil.

10. Dispositif de conversion de puissance (20) selon la revendication 8, dans lequel

le processeur
calcule la valeur d'estimation de la déviation de phase en effectuant la commande proportionnelle et la commande intégrale de telle sorte que la déviation de puissance entre puissances réactives est égale à zéro dans une plage de vitesses basses où une valeur d'ordre de fréquence est inférieure à une valeur seuil, et calcule la valeur d'estimation de la déviation de phase via une méthode de tension induite élargie dans une plage de vitesses moyennes/élevées où la valeur d'ordre de fréquence est égale ou supérieure à la valeur seuil.

11. Dispositif de conversion de puissance (20) selon la revendication 9,
le dispositif comprenant :

un dispositif de stockage qui stocke la valeur seuil et une réponse de commande utilisée pour la commande proportionnelle ou la commande intégrale ;
un dispositif d'entrée (20b) qui fixe la valeur seuil et la réponse de commande ; ou
un dispositif de communication qui communique avec un dispositif externe destiné à fixer la valeur seuil et la réponse de commande.

12. Dispositif de conversion de puissance (20) selon la revendication 11, dans lequel

le processeur
transmet des valeurs d'ordre de tension, des valeurs de détection de courant, et une valeur d'estimation de la déviation de phase à un contrôleur d'un dispositif supérieur via le dispositif de communication,
reçoit des inductances d'un axe d et d'un axe q du moteur magnétique (1) ou un coefficient de tension induite, les inductances et le coefficient de tension induite étant analysés sur une base des valeurs d'ordre de tension, des valeurs de détection de courant, et de la valeur d'estimation de la déviation de phase, à partir du contrôleur du dispositif supérieur via le dispositif de communication, et
met à jour les paramètres de circuit électrique avec les valeurs reçues.

13. Dispositif de conversion de puissance (20) selon la revendication 1, dans lequel

le processeur
calcule la deuxième puissance ($Q_c^{\wedge}$) à partir des paramètres de circuit électrique, de composantes continues et de composantes transitoires de valeurs de détection de courant ou de valeurs d'ordre de courant d'un axe d et d'un axe q (id*, iq*), et de la valeur d'estimation de fréquence ($\omega$dc).

# FIG. 1

EP 4 554 081 B1

# FIG. 2

EP 4 554 081 B1

$$\Delta \theta_c = \tan^{-1} \left[ \frac{V_{dc}** - R*i_{dc} + \omega_{dc}L_q* i_{qc}}{V_{qc}** - R*i_{qc} - \omega_{dc}L_q* i_{dc}} \right]$$

8

81

$\Delta \theta_{c\_H}$

# FIG. 3

EP 4 554 081 B1

# FIG. 4

# FIG. 5

(a) R/R* = 1.0

(b) R/R* = 0.5

# FIG. 6

EP 4 554 081 B1

# FIG. 7

EP 4 554 081 B1

# FIG. 8

# FIG. 9

EP 4 554 081 B1

# FIG. 10

EP 4 554 081 B1

9a

9a4

$\boxed{0}$

9a1

$\boxed{V_1{}^* \, i_1 \, \mathrm{Sin}\, \theta_{vi}}$

$Q_c$

9a3

$\Delta Q_c$

9a5

$\boxed{\begin{array}{c}\mathrm{PI}\\ \mathrm{CONTROL}\end{array}}$

$\Delta \theta_{c\_L}$

9a2

$$\boxed{\begin{array}{l} -\omega_{dc}(L_d{}^* \, i_{dc}{}^2 + L_q{}^* \, i_{qc}{}^2) - \omega_{dc}K_e{}^* \, i_{dc} \\ +L_q{}^* \, i_{qc}d/dt(i_{dc}) - L_d{}^* \, i_{dc}d/dt(i_{qc}) \end{array}}$$

$\hat{Q_c}$

FIG. 11

EP 4 554 081 B1

# FIG. 12

8a

8a4

8a5

8a1

$V_{dc}^{**} i_{dc} + V_{qc}^{**} i_{qc}$

$P_c$

8a3

$\Delta P_c$

0

PI CONTROL

$\Delta \theta_{c\_H}$

$-$

$+$

$-$

$+$

8a2  $P_c^{\hat{}}$

$R^*(i_{dc}^2 + i_{qc}^2) + \omega_{dc}(L_d^* - L_q^*) i_{dc} i_{qc} + \omega_{dc} K_e^* i_{qc}$

$L_d^* i_{dc} d/dt(i_{dc}) + L_q^* i_{qc} d/dt(i_{qc})$

# FIG. 13

EP 4 554 081 B1

## FIG. 14

8b

8b1: $V_1 * i_1 \cos\theta_{vi}$ → $P_c$

8b5: PI CONTROL → $\Delta\theta_{c\_H}$

8b4: 0

8b3: $\Delta P_c$

8b2: $\hat{P_c}$
$$R^* (i_{dc}{}^2 + i_{qc}{}^2) + \omega_{dc}(L_d{}^* - L_q{}^*) i_{dc}\, i_{qc} + \omega_{dc}K_e{}^* i_{qc}$$
$$L_d{}^* i_{dc}\, d/dt(i_{dc}) + L_q{}^* i_{qc}\, d/dt(i_{qc})$$

FIG. 15

EP 4 554 081 B1

# FIG. 16

EP 4 554 081 B1

**EP 4 554 081 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 4402600 A
- JP 4402600 B
- CN 116830450 A
- US 2007126391 A1
- US 11273712 B2
- EP 1681762 A2